(19) Europäisches Patentamt
European Patent Office
Office européen des brevets

(11) Publication number: 0 349 265
A2

(12) # EUROPEAN PATENT APPLICATION

(21) Application number: 89306509.4

(51) Int. Cl.4: H05B 33/26 , H05B 33/14

(22) Date of filing: 27.06.89

(30) Priority: 27.06.88 US 211616

(43) Date of publication of application:
03.01.90 Bulletin 90/01

(84) Designated Contracting States:
AT BE CH DE ES FR GB GR IT LI LU NL SE

(71) Applicant: EASTMAN KODAK COMPANY (a New Jersey corporation)
343 State Street
Rochester New York 14650(US)

(72) Inventor: Scozzafava, Michael c/o EASTMAN KODAK COMPANY
Patent Department 343 State Street
Rochester New York 14650(US)

(74) Representative: Davis, Ian Ellison et al
Kodak Limited Patent Department Headstone Drive
Harrow Middlesex HA1 4TY(GB)

(54) **Electroluminescent devices.**

(57) A matrix addressed organic electroluminescent device providing extremely small pixel sizes comprises anode strips, an organic electroluminescent medium coated on the anode strips, and cathode strips coated on the organic electroluminescent medium. The cathode strips are formed by photolithographic techniques which do not damage the organic electroluminescent medium. In one preferred embodiment the electroluminescent medium includes a fluorescent material which emits light in response to hole-electron recombination.

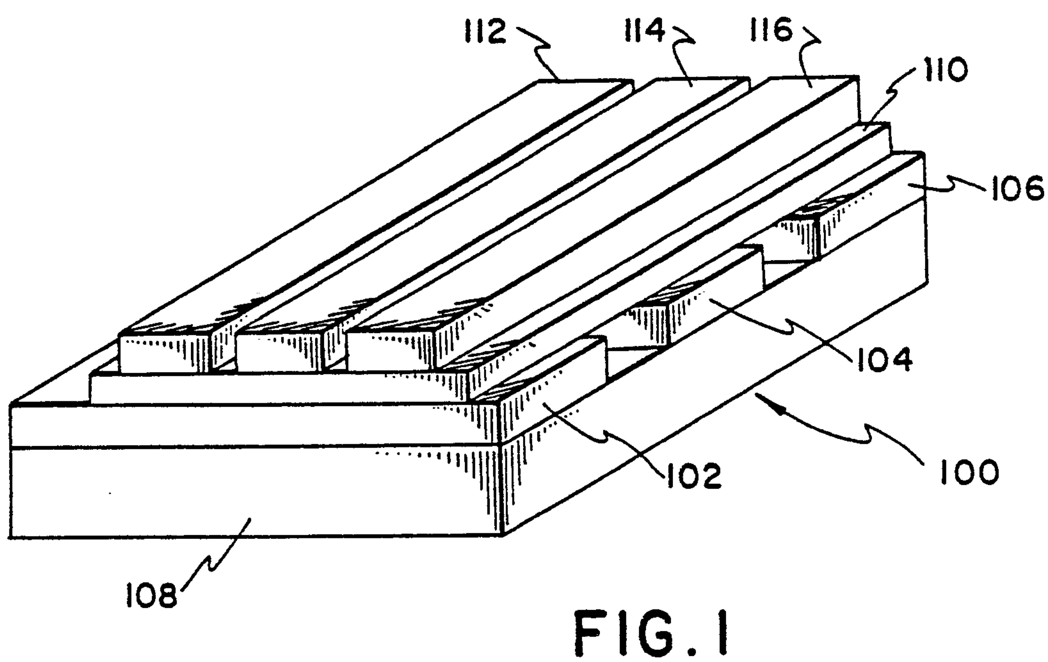


FIG. 1

EP 0 349 265 A2

## ELECTROLUMINESCENT DEVICES

This invention relates to electroluminescent devices, also known as EL devices. More specifically, it relates to matrix addressed organic EL devices.

Inorganic matrix addressed electroluminescent devices for use in flat panel displays have been described in the literature. See, for example, "Flat Panel Displays and CRTs" by L. E. Tannas, Jr., VanNostrand Reinhold Company, New York, 1984, especially Chapter 8. In these devices, the luminance is produced by applying an electric field to a thin layer of a polycrystalline inorganic phosphor, such as ZnS:Mn phosphors, positioned between two inorganic dielectric layers. Inorganic phosphors, however, have certain disadvantages. For example, they do not provide a wide range of spectral selectivity. Furthermore, as compared with organic devices, EL devices with thin inorganic phosphor layers are not easy to fabricate. This is important because the luminance of the EL device depends on the strength of the electrical field. A very thin electroluminescent layer, therefore, is desirable for providing adequate luminance without requiring such high voltage as to cause electrical breakdown across the layer.

The use of organic electroluminescent materials in EL devices has been known for over two decades, having been disclosed, for example, by Gurnee et al, U.S. Patent 3,172,862, issued March 9, 1965. Other early descriptions of organic EL devices are found in Gurnee, U.S. Patent 3,173,050 of March 9, 1965; Dresner, "Double Injection Electroluminescence in Anthracene", RCA Review, Vol.30, pp. 322-334, 1969; and Dresner U.S. Patent 3,710,167 of January 9, 1973.

The most recent discoveries in the art of organic EL device construction have resulted from EL device constructions with two extremely thin layers (<1.0μm in combined thickness) separating the anode and cathode, one specifically chosen to transport holes and the other specifically chosen to transport electrons and acting as the organic luminescent zone of the device. This has allowed applied voltages to be reduced for the first time into ranges approaching compatibility with integrated circuit drivers, such as field effect transistors. At the same time light outputs at these low driving voltages have been sufficient to permit observation under common ambient lighting conditions.

For example, Tang U.S. Patent 4,356,429 discloses in Example 1 an EL device formed of a conductive glass transparent anode, a 1000 Angstroms hole transporting layer of copper phthalocyanine, a 1000 Angstroms electron transporting layer of tetraphenylbutadiene in poly(styrene) also acting as the luminescent zone of the device, and a silver cathode. The EL device emitted blue light when biased at 20 volts at an average current density in the range of 30 to 40 $mA/cm^2$. The brightness of the device was 5 $cd/m^2$. Tang teaches useful cathodes to be those formed from common metals with a low work function, such as indium, silver, tin, and aluminum.

A further improvement in organic layer EL devices is taught by Van Slyke et al U.S. Patent 4,539,507. Referring to Example 1, onto a transparent conductive glass anode were vacuum vapor deposited successive 750 Angstrom hole transporting 1,1-bis(4-di-p-tolylaminophenyl)cyclohexane and electron transporting 4,4′-bis(5,7-di-t-pentyl-2-benzoxzolyl)stilbene layers, the latter also providing the luminescent zone of the device. Indium was employed as the cathode. The EL device emitted blue-green light (520 nm peak). The maximum brightness achieved was 340 $cd/m^2$ at a current density of about 140 $mA/cm^2$ when the applied voltage was 22 volts. The maximum power conversion efficiency was about $1.4 \times 10^{-3}$ watt/watt, and the maximum EL quantum efficiency was about $1.2 \times 10^{-2}$ photon/electron when driven at 20 volts. Silver, tin, lead, magnesium, manganese, and aluminum are specifically mentioned for cathode construction.

Van Slyke et al U.S. Patent 4,720,432 discloses an organic EL device comprised of, in the sequence recited, an anode, an organic hole injecting and transporting zone, an organic electron injecting and transporting zone, and a cathode. The organic EL device is further characterized in that the organic hole injecting and transporting zone is comprised of a layer in contact with the anode containing a hole injecting porphyrinic compound and a layer containing a hole transporting aromatic tertiary amine interposed between the hole injecting layer and the electron injecting and transporting zone.

These recent improvements have increased the opportunity for practical uses of organic EL devices. Until now, however, matrix addressed organic EL devices have not been available. In particular, the construction of organic EL devices capable of generating small pixel displays has not been feasible.

Vapor deposition with shadow masking which has been used for inorganic EL devices (See Tannas, cited above, page 264) has not been satisfactory for making devices with very fine lines because the lines deposited by that method are too coarse. Photolithography has also been considered unsuitable for making organic EL devices because the commonly used photoresist compositions employ developing solvents that can damage the organic electroluminescent material either by leaking through pinholes in the electrode layer or by entering through the edges of the laminate.

It is an object of the present invention to provide novel matrix addressed organic EL devices with very fine electrode lines and small pixel sizes which are fabricated without damage to the organic layers.

The object of the invention is achieved by an electroluminescent device comprised of an anode, a planar electroluminescent medium coated on said anode, and a cathode coated on said electroluminescent medium, characterized in that the planar electroluminescent medium is comprised of an organic hole injecting zone adjacent the anode and an organic electron injecting luminescent zone adjacent the cathode, the anode is comprised of a plurality of laterally spaced strips contacting the organic hole injecting zone, the strips having a center-to-center spacing of less than 400µm, the cathode is comprised of a plurality of laterally spaced strips contacting the organic electron injecting luminescent zone, the strips having a center-to-center spacing of less than 400µm, and the cathode and anode strips are relatively oriented to be in part superimposed over and in part laterally offset from each other.

In preferred embodiments of the invention the EL device not only is an organic matrix addressed device, but also includes one or more of the following features:

a) The luminescent zone between the hole-injecting zone and the cathode is formed by a thin film of less than 1 µm in thickness comprised of an organic host material capable of sustaining both hole and electron injection and a fluorescent material which emits light in response to hole-electron recombination. This embodiment provides an organic matrix addressed device having a broad range of light output wavelengths and high stability levels.

b) The hole injecting zone in contact with the anode contains a hole-injecting porphyrinic compound and a layer containing a hole-transporting aromatic amine between the hole-injecting compound and the electron injecting zone. This embodiment provides the additional advantages of improved stability and sustained operating performance.

c) The cathode strips of the matrix addressed device comprise a plurality of metals other than alkali metals, at least one of which has a work function less than 4 eV. This embodiment of the invention provides the additional advantages of superior stability of the cathode and of the device as a whole.

The new type of EL device provides a combination of valuable properties not heretofore available. It provides the capabilities of matrix addressing in flat panel displays having small pixel sizes. In addition, the organic electroluminescent medium can be extremely thin, thus allowing low voltages. Spectral selectivity is possible, especially in the preferred embodiment of the invention in which the luminescent zone contains a fluorescent material. Furthermore, in the preferred embodiments the invention provides the advantages of an organic matrix addressed EL device, along with one or more of the additional advantages mentioned with respect to items a), b) and c) above. As will be described in more detail, the new type of device is made possible by fabrication procedures not previously considered suitable for the fabrication of organic EL devices.

The present invention will now be described by way of example with reference to the accompanying drawings, in which:-

Fig. 1 is an enlarged schematic perspective view of a portion of one embodiment of an EL device of the invention; and

Figs. 2 and 3 are enlarged schematic cross-sections of individual pixels in two different embodiments of an EL device of the invention.

The drawings are necessarily schematic because the layers are too thin and the thickness differences too great for showing the layers in true scale.

Fig. 1 shows a small portion of a matrix addressed organic electroluminescent or EL device 100 of the invention. In this device, the anode comprises a plurality of laterally spaced, parallel, electrically conductive, transparent metallic strips 102, 104 and 106 which are supported on a transparent glass substrate 108. Above the anode strips is a planar organic electroluminescent medium 110 which separates the anode strips from the cathode, the latter being in the form of a plurality of laterally spaced, parallel electrically conductive metallic strips 112, 114 and 116. The anode and cathode strips thus form rows and columns and are relatively oriented to be in part superimposed and in part laterally offset from each other. As shown in Figure 1, the major axes of the anode strips are parallel, and the major axes of the cathode strips are parallel. Viewed normal to the planar organic electroluminescent medium, the major axes of the anode strips are angularly oriented relative to the major axes of the cathode strips so that the major axes of the anode and cathodes strips are perpendicular to each other. However, the desired partial overlapping and partial offset relationship of the anode and cathode strips can be achieved when their relative angular orientation differs from the perpendicular relationship shown-e.g., the anode and cathode strip major axes are angularly oriented relative to each other at an angle ranging from 30 to 150 degrees. The anode and cathode strips can be connected in a conventional manner to an external power source not shown in the drawing. The power source can be a continuous direct current or an alternating current voltage source or an

intermittent current voltage source. Any convenient conventional power source, including any desired switching circuitry, can be employed which is capable of positively biasing the anode with respect to the cathode. Either the anode or cathode can be at ground potential.

The planar electroluminescent medium 110 is shown for simplicity in Fig. 1 as a single layer. The electroluminescent medium is referred to as planar since its thickness is quite small in relation to its length and width. As will be described in more detail with reference to Figs. 2 and 3, the planar electroluminescent medium 110 can, and preferably does, include a plurality of layers or zones.

An EL device can be viewed as a diode which is forward biased when the anode is at a higher potential than the cathode. Under these conditions the anode injects holes (positive charge carriers) into the planar electroluminescent medium while the cathode injects electrons into the planar electroluminescent medium. The portion of the electroluminescent medium adjacent the anode thus forms a hole injecting and transporting zone while the portion adjacent the cathode forms an electron injecting and transporting zone. The injected holes and electrons each migrate toward the oppositely charged electrode. This results in recombination of holes and electrons within the organic electroluminescent medium. When a migrating electron drops from its conduction potential to a valence band in filling a hole, energy is released as light. Hence the organic electroluminescent medium forms between the electrodes a luminescent zone receiving mobile charge carriers from each electrode. Depending upon the choice of alternative constructions, the released light can be emitted from the electroluminescent material through the anode or through the cathode or through both.

Reverse biasing of the electrodes reverses the direction of mobile charge migration, interrupts charge injection, and terminates light emission. The most common mode of operating organic EL devices is to employ a forward biasing d.c. power source and to rely on external current interruption or modulation to regulate light emission.

In the matrix addressed device of the invention, the power source, such as electronic drivers, sends an electronic charge through the grid formed by the rows and columns of the anode and cathode. A pixel is at the intersection of each row and column; i.e., where the anode and cathode strips are superimposed. Pixels light up when the axis at an intersection is charged to a threshold voltage.

In the organic EL devices of the invention it is possible to maintain a current density compatible with efficient light emission while employing a relatively low voltage across the electrodes by limiting the total thickness of the organic electroluminescent medium to less than 1µm (10,000 Angstroms). At a thickness of less than 1µm an applied voltage of 20 volts results in a field potential of greater than 2 X $10^5$ volts/cm, which is compatible with efficient light emission. As more specifically noted below, preferred thicknesses of the organic electroluminescent medium in the range from 0.1 to 0.5µm (1,000 to 5,000 Angstroms), allowing further reductions in applied voltage and/or increase in the field potential, are well within device construction capabilities.

To form light transmissive electrodes, a plurality of translucent or transparent metallic strips are formed either on the organic electroluminescent medium and/or on a separate translucent or transparent support such as transparent substrate 108 of Fig. 1. The thickness of the strips is determined by balancing light transmission (or extinction) and electrical conductance (or resistance). A practical balance in forming a light transmissive metallic electrode is for the conductive strips to be in the thickness range of from about 50 to 250 Angstroms. If the electrode is not intended to transmit light, any greater thickness found convenient in fabrication can be employed.

EL device 100 shown in Figure 1 and the pixel 200 of such a device shown in cross-section in Fig. 2 illustrate one preferred embodiment of the invention. Because of the historical development of organic EL devices it is customary to employ a light transmissive anode. This is achieved by providing a light transmissive insulative support 108 in Fig. 1 and 201 in Fig. 2 onto which is deposited a conductive relatively high work function metal or metal oxide transparent layer to form the anode. As shown in Fig. 1, the anode is formed in a pattern of strips 102, 104 and 106 by known procedures. When the support is a transparent glass plate, conventional photolithography can be used since glass is not damaged by conventional photolithographic developing solvents. The cross-section 203 of one such strip is shown in Fig. 2. Since the portion of the organic electroluminescent medium immediately adjacent the anode acts as a hole transporting zone, as Fig. 2 shows, it is preferably formed by depositing on the anode a layer 205 of an organic material chosen for its hole transporting efficiency. Over the hole transporting layer is deposited a layer 207 of an organic material chosen for its electron transporting efficiency. A section 209 of one of the cathode strips overlies the electron transporting upper layer of the organic electroluminescent medium.

Figure 3 illustrates in cross section a single pixel 300 of another preferred embodiment of the invention. Contrary to the historical pattern of organic EL device development, light emission from the pixel 300 is through the light transmissive cathode 309. While the anode of the device 300 can be formed identically as

the device 200, thereby permitting light emission through both anode and cathode, in the preferred form, the device 300 employs an opaque charge conducting material to form the anode strips 301, such as a relatively high work function metal. The hole and electron transporting layers 305 and 307 can be identical to the corresponding layers 205 and 207 of the device 200. The significant difference between devices 200 and 300 is that the latter employs thin, light transmissive cathode strips 309 in place of the opaque cathode customarily included in organic EL devices.

While the organic electroluminescent medium of the EL devices 200 and 300 is described above as being comprised of a single organic hole injecting and transporting layer and a single electron injecting and transporting layer, further elaboration of each of these layers into multiple layers, as more specifically described below, can result in further enhancement of device performance. When multiple electron injecting and transporting layers are present, the layer receiving holes is the layer in which hole-electron recombination occurs and therefore forms the luminescent zone of the device.

To fabricate the matrix addressed organic EL devices of the invention, a convenient sequence of steps is first to form the anode strips on a transparent substrate. Although a number of metallic substances are useful as transparent or as non-transparent anode materials, one preferred transparent anode material for this purpose is commercially available under the trademark "Nesatron". This consists of a thin, transparent layer of indium tin oxide (ITO) on glass. The transparent conductive layer preferably has a thickness ranging from about 0.1 to 1.0 µm. The glass sheets are cut to a desired size and then cleaned and polished. The conductive layer is transformed to the desired pattern of narrow parallel anode strips by a conventional etching procedure. In an exemplary procedure 1) the sheet is cleaned in dichloromethane; 2) the cleaned sheet is coated with a photoresist composition; 3) the coated sheet is spin dried; 4) the coating is baked at 80°C for 30 minutes; 5) the coating is placed in contact with a mask of the desired line pattern and exposed for 3 seconds to UV radiation; and 6) the exposed coating is developed by contact for about 90 seconds with the solvent, and then rinsed with n-heptane and air dried.

After forming the transparent anode strips on the transparent substrate, a thin layer of organic electroluminescent material is deposited over the anode strips, preferably by vacuum deposition. As will be described in more detail later, a wide variety of such organic materials can be used, although certain materials provide special advantages in combination with a matrix addressed EL device. The organic material in one exemplary form comprises a first layer of a hole transporting compound, such as an aromatic tertiary amine, and a second layer of an electron transporting compound, such as a chelated oxinoid compound which forms the luminescent zone. These two layers can be deposited by evaporation from a heated quartz boat. On top of the organic electroluminescent material is then deposited a thin uniform layer of the cathode material. Suitable materials and thicknesses for the cathode are later described in more detail.

Photolithography is then used to pattern the cathode layer in narrow strips extending in a direction normal to the direction of the anode strips. For this purpose a solution of a crosslink able photoresist composition is coated in a continuous layer over the cathode layer. A preferred method of applying the photoresist composition to the cathode layer is by spin coating. Other methods, such as knife coating, can also be used provided care is taken to avoid scratching the substrate. A particularly useful class of polymerizable and crosslinkable monomers which, mixed with a photoinitiator, can be coated from a solvent and then polymerized and crosslinked by UV radiation is disclosed in U.S. Patent Nos. 4,322,490 and 4,619,890. Especially useful are the benzene tricarboxylic acid alkyl acrylic esters of U.S. Patent No. 4,619,890. These monomers are mixed with a photoinitiator, such as an amine activator, and a 3-ketocoumarin sensitizer in a solvent, such as 2-ethoxyethanol ethanol, which does not dissolve the organic electroluminescent material of the EL cell. Examples of useful photoinitiators and solvents are disclosed in the cited U.S. patents.

The fabrication of a matrix addressed organic EL device of the invention is illustrated by the following example.

## Example

a) A transparent sheet of anode material consisting of an indium tin oxide (ITO) layer on glass is cut to 10 cm by 10 cm size squares. The metallic coating is polished with 0.05µm alumina abrasive for a few minutes, followed by ultrasonic cleaning in a 1:1 (volume) mixture of isopropyl alcohol and distilled water, then rinsed with isopropyl alcohol and blown dry with nitrogen. Thereafter, the metallic layer is transformed to a layer of thin parallel anode strips, 275µm in width and less than 400µm center-to-center spacing.

b) A hole injecting transporting layer of the aromatic tertiary amine, 1,1-bis(4-di-p-tolylaminophenyl)-

cyclohexane (750Å in thickness) is then deposited over the anode strips by evaporation from a quartz boat heated by a tungsten filament.

c) An electron injecting and transporting layer (750Å) forming the luminescent zone is deposited on the hole injecting and transporting layer. Aluminum trisoxine (CO-1) is used as a host material, being evaporated from a quartz boat heated by a tungsten filament.

d) On top of the luminescent zone is deposited to a thickness of 0.22 μm a cathode layer of Mg and In in an atomic ratio of 10:1.

e) The cathode layer is then patterned by photolithography in parallel strips, 275μm in width, in a direction normal to the direction of the anode strips. The photoresist composition is the photopolymerizable and crosslinkable monomer, tri(2-acryloylethyl)-1,3,5-benzene tricarboxylate. This monomer is polymerized by a free radical mechanism, the free radical being generated through the interaction of a sensitizer and an activator. The patterning steps are as follows:

1) The monomer is spin coated from the solvent 2-ethoxyethanol.

2) The monomer layer is exposed to UV irradiation through a proximity mask providing the desired pattern.

3) The uncrosslinked monomer in the unexposed areas is removed by dipping the array in 2-ethoxyethanol for a few seconds.

4) The resulting exposed metal is then removed by dipping the array in an acid etch bath consisting of a 1000:1 water:sulfuric acid solution.

5) After etching, the array is rinsed in water and spun to remove excess water. The final patterned array as in Fig. 1 is a 100 line by 100 line array on a 3.8 cm by 3.8 cm active cell area having pixel sizes of about 275μm and the anode and cathode strips having center-to-center spacing, of about 375μm.

The procedure illustrated in the example offers several important advantages; for example,

a) It uses a simple photolithographic process;

b) It employs solvents which leave the organic electroluminescent media intact;

c) Larger areas can be patterned than are feasible with the conventional technique of shadow masking; and

d) Much smaller pixel sizes are possible, e.g., less than 300μm, than are possible with shadow masking. More particularly, the pixel sizes in preferred embodiments can be less than 200μm in edge length and, more preferably, less than 50μm. Likewise, the center-to-center spacing of the strips can be on the order of 400μm or much narrower for the narrower strip widths, e.g., preferably less than 300μm and optimally less than 100μm, allowing correspondingly smaller pixels to be formed.

In its broadest aspects, the matrix addressed organic EL device of the invention can employ any organic electroluminescent material and any electrode materials which are suitable for EL devices. The device of the invention, however, offers its greatest advantages when formed in combination with one or more of the preferred materials referred to above. Namely, (a) a thin, luminescent zone containing a fluorescent material, (b) a layer containing a hole-injecting porphyrinic compound in contact with the anode and/or (c) a cathode comprising at least one metal (other than an alkali metal) having a low work function. In the event that the luminescent zone does not contain a fluorescent material, the electroluminescent material can, however, include any of the various organic materials which are disclosed below as host materials for the fluorescent material.

In the preferred embodiment in which the luminescent zone contains a fluorescent material, the luminescent zone is a thin film (herein employed to mean less than 1μm in thickness) comprised of an organic host material capable of sustaining hole and electron injection and a fluorescent material capable of emitting light in response to hole-electron recombination. It is preferred that the luminescent zone be maintained in a thickness range of from 50 to 5000 Angstroms and, optimally, 100 to 1000 Angstroms, so that the entire organic electroluminescent medium can be less than 1μm and preferably less than 1000 Angstroms in thickness.

The host material can be conveniently formed of any material heretofore employed as the active component of a thin film luminescent zone of an organic EL device. Among host materials suitable for use in forming thin films are diarylbutadienes and stilbenes, such as those disclosed by Tang U.S. Patent 4,356,429, cited above.

Still other thin film forming host materials which can be employed are optical brighteners, particularly those disclosed by Van Slyke et al U.S. Patent 4,539,507, cited above. Useful optical brighteners include those satisfying structural formulae (I) and (II):

(I)

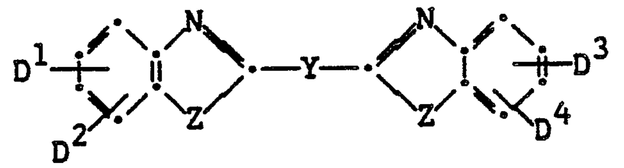

or

(II)

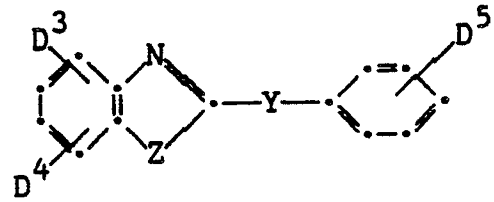

wherein

$D^1$, $D^2$, $D^3$, and $D^4$ are individually hydrogen; saturated aliphatic of from 1 to 10 carbon atoms, for example, propyl, t-butyl, heptyl, and the like; aryl of from 6 to 10 carbon atoms, for example, phenyl and naphthyl; or halo such as chloro, fluoro, and the like; or $D^1$ and $D^2$ or $D^3$ and $D^4$ taken together comprise the atoms necessary to complete a fused aromatic ring optionally bearing at least one saturated aliphatic of from 1 to 10 carbon atoms, such as methyl, ethyl, propyl and the like;

$D^5$ is a saturated aliphatic of from 1 to 20 carbon atoms, such as methyl, ethyl, n-eicosyl, and the like; aryl of from 6 to 10 carbon atoms, for example, phenyl and naphthyl; carboxyl; hydrogen; cyano; or halo, for example, chloro, fluoro and the like; provided that in formula (II) at least two of $D^3$, $D^4$ and $D^5$ are saturated aliphatic of from 3 to 10 carbon atoms, e.g., propyl, butyl, heptyl and the like;

Z is O-, -N($D^6$)-, or -S-; and

Y is

$-D^7(CH{=}CH)_nD^7-$, 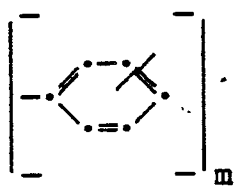, $-CH{=}CH-$,

$(CH{=}CH)_mD^7(CH{=}CH)_n$, or 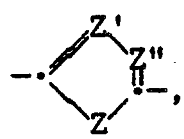,

wherein

m is an integer of from 0 to 4;

n is arylene of from 6 to 10 carbon atoms, for example, phenylene and naphthylene; and

$D^6$ is hydrogen; a saturated aliphatic substituent of from 1 to 10 carbon atoms, such as an alkyl substituent; aryl of from 6 to 10 carbon atoms, such as phenyl or naphthyl; or a halo substituent, such as chloro or fluoro;

$D^7$ is arylene of from 6 to 10 carbon atoms, such as phenyl or naphthyl;

$Z'$ and $Z''$ are individually N or CH.

As used herein "aliphatic" includes substituted aliphatic as well as unsubstituted aliphatic. The substituents in the case of substituted aliphatic include alkyl of from 1 to 5 carbon atoms, for example, methyl, ethyl, propyl and the like; aryl of from 6 to 10 carbon atoms, for example, phenyl and naphthyl; halo, such as chloro, fluoro and the like; nitro; and alkoxy having 1 to 5 carbon atoms, for example, methoxy, ethoxy, propoxy, and the like.

Still other optical brighteners that are contemplated to be useful are listed in Vol. 5 of Chemistry of Synthetic Dyes, 1971, pages 618-637 and 640. Those that are not already thin-film-forming can be rendered so by attaching an aliphatic moiety to one or both end rings.

Particularly preferred host materials for forming the luminescent zone of the organic EL devices of this

invention are metal chelated oxinoid compounds, including chelates of oxine (also commonly referred to as 8-quinolinol or 8-hydroxyquinoline). Such compounds exhibit both high levels of performance and are readily fabricated in the form of thin films. Exemplary of contemplated oxinoid compounds are those satisfying structural formula (III):

(III)

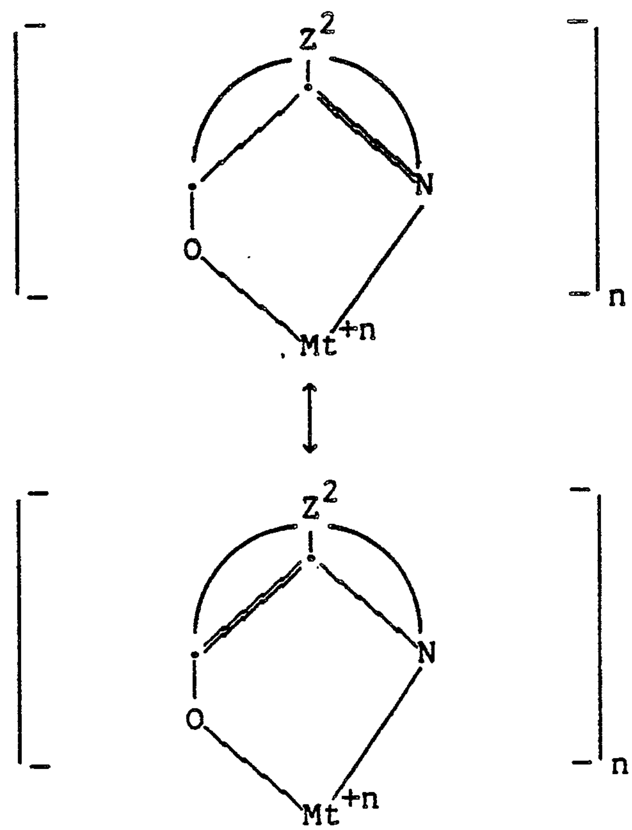

wherein

Mt represents a metal;

n is an integer of from 1 to 3; and

$Z^2$ independently in each occurrence represents the atoms completing a nucleus having at least two fused aromatic rings.

From the foregoing it is apparent that the metal can be monovalent, divalent, or trivalent metal. The metal can, for example, be an alkali metal, such as lithium, sodium, or potassium; an alkaline earth metal, such as magnesium or calcium; or an earth metal, such as boron or aluminum. Generally any monovalent, divalent, or trivalent metal known to be a useful chelating metal can be employed.

$Z^2$ completes a heterocyclic nucleus containing at least two fused aromatic rings, at one of which is an azole or azine ring. Additional rings, including both aliphatic and aromatic rings, can be fused with the two required rings, if required. To avoid adding molecular bulk without improving on function the number of ring atoms is preferably maintained at 18 or less.

Illustrative of useful host materials capable of being used to form thin films are the following:

HM-1 Aluminum trisoxine
[a.k.a.*, tris(8-quinolinol) aluminum]

HM-2 Magnesium bisoxine
[a.k.a., bis(8-quinolinol) magnesium]

HM-3 Bis[benzo{f}-8-quinolinol] zinc

HM-4 Bis(2-methyl-8-quinolinolato) aluminum oxide

HM-5 Indium trisoxine
[a.k.a., tris(8-quinolinol) indium]

HM-6 Aluminum tris(5-methyloxine)
[a.k.a., tris(5-methyl-8-quinolinol) aluminum

HM-7 Lithium oxine
(a.k.a., 8-quinolinol lithium]

HM-8 Gallium trisoxine
[a.k.a, tris(5-chloro-8-quinolinol) gallium]

HM-9 Calcium bis(5-chlorooxine)
[a.k.a, bis(5-chloro-8-quinolinol) calcium]

HM-10 Poly[zinc (II)-bis(8-hydroxy-5-quinolinyl)methane]

HM-11 Dilithium epindolidione

HM-12 1,4-Diphenylbutadiene

HM-13 1,1,4,4-Tetraphenylbutadiene

HM-14 4,4'-Bis[5,7-di(t-pentyl-2-benzoxazolyl)]-stilbene

HM-15 2,5-Bis[5,7-di(t-pentyl-2-benzoxazolyl)]-thiophene

HM-16 2,2'-(1,4-phenylenedivinylene)bisbenzothiazole

HM-17 4,4'-(2,2'-Bisthiazolyl)biphenyl

HM-18 2,5-Bis[5-(α,α-dimethylbenzyl)-2-benzoxazolyl]thiophene

(* a.k.a. is employed in each occurrence as an abbreviation for "also known as").

HM-19 2,5-Bis[5,7-di(t-pentyl)-2-benzoxazolyl]-3,4-diphenylthiophene

HM-20 Trans-stilbene

All of the host materials listed above are known to emit light in response to hole and electron injection.

By blending with the host material a minor amount of a fluorescent material capable of emitting light in response to hole-electron recombination the hue of light emitted from the luminescent zone can be modified. In theory, if a host material and a fluorescent material could be found for blending which have exactly the same affinity for hole-electron recombination each material should emit light upon injection of holes and electrons in the luminescent zone. The perceived hue of light emission would be the visual integration of both emissions.

Since imposing such a balance of host and fluorescent materials is highly limiting, it is preferred to choose the fluorescent material so that it provides the favored sites for light emission. When only a small proportion of fluorescent material providing favored sites for light emission is present, peak intensity wavelength emissions typical of the host material can be entirely eliminated in favor of a new peak intensity wavelength emission attributable to the fluorescent material. While the minimum proportion of fluorescent material sufficient to achieve this effect varies by the specific choice of host and fluorescent materials, in no instance is it necessary to employ more than about 10 mole percent fluorescent material, based on moles of host material and seldom is it necessary to employ more than 1 mole percent of the fluorescent material. On the other hand, for any host material capable of emitting light in the absence of fluorescent material, omitting or limiting the fluorescent material to extremely small amounts, e.g., less than about $10^{-3}$ mole percent, based on host material, can result in retaining emission at wavelengths characteristic of the host material. Thus, by choosing the proportion of a fluorescent material capable of providing favored sites for light emission, either a full or partial shifting of emission wavelengths can be realized. This allows the spectral emissions of the EL devices of this invention to be selected and balanced to suit the application to be served.

Choosing fluorescent materials capable of providing favored sites for light emission necessarily involves relating the properties of the fluorescent material to those of the host material. The host material can be viewed as a collector for injected holes and electrons with the fluorescent material providing the molecular sites for light emission. One important relationship for choosing a fluorescent material capable of modifying the hue of light emission when present in a host material is a comparison of the reduction potentials of the two materials. The fluorescent materials demonstrated to shift the wavelength of light emission have exhibited a less negative reduction potential than that of the host material. Reduction potentials, measured in electron volts, have been widely reported in the literature along with varied techniques for their measurement. Since it is a comparison of reduction potentials rather than their absolute values which is desired, it is apparent that any accepted technique for reduction potential measurement can be employed, provided both the fluorescent and host material reduction potentials are similarly measured. A preferred oxidation and reduction potential measurement technique is reported by R. J. Cox, Photographic Sensitivity, Academic Press, 1973, Chapter 15.

A second important relationship for choosing a fluorescent material capable of modifying the hue of light emission when present in a host material is a comparison of the bandgap potentials of the two materials. The fluorescent materials demonstrated to shift the wavelength of light emission have exhibited a lower bandgap potential than that of the host material. The bandgap potential of a molecule is taken as the potential difference in electron volts (eV) separating its ground state and first singlet state. Bandgap potentials and techniques for their measurement have been widely reported in the literature. The bandgap potentials herein reported are those measured in electron volts (eV) at an absorption wavelength which is bathochromic to the absorption peak and of a magnitude one tenth that of the magnitude of the absorption peak. Since it is a comparison of bandgap potentials rather than their absolute values which is desired, it is apparent that any accepted technique for bandgap measurement can be employed, provided both the fluorescent and host material band gaps are similarly measured. One illustrative measurement technique is disclosed by F. Gutman and L. E. Lyons, Organic Semiconductors, Wiley, 1967, Chapter 5.

Where a host material is chosen which is itself capable of emitting light in the absence of the fluorescent material, it has been observed that suppression of light emission at the wavelengths of emission characteristic of the host material alone and enhancement of emission at wavelengths characteristic of the fluorescent material occurs when spectral coupling of the host and fluorescent materials is achieved. By spectral coupling it is meant that an overlap exists between the wavelengths of emission characteristic of the host material alone and the wavelengths of light absorption of the fluorescent material in the absence of the host material. Optimal spectral coupling occurs when the maximum emission of the host material alone substantially matches within ± 25 nm the maximum absorption of the fluorescent material alone. In practice advantageous spectral coupling can occur with peak emission and absorption wavelengths differing by up to 100 nm or more, depending on the width of the peaks and their hypsochromic and bathochromic slopes. Where less than optimum spectral coupling between the host and fluorescent materials is contemplated, a bathochromic as compared to a hypsochromic displacement of the fluorescent material produces more

efficient results.

Although the foregoing discussion has been undertaken by reference to host materials which are known to themselves emit light in response to hole and electron injection, in fact light emission by the host material itself can entirely cease where light emission by the fluorescent material is favored by any one or combination of the various relationships noted above. It is appreciated that shifting the role of light emission to the fluorescent material allows a still broader range of choices of host materials. For example, one fundamental requirement of a material chosen to emit light is that it must exhibit a low extinction coefficient for light of the wavelength it emits to avoid internal absorption. The present invention permits use of host materials in matrix addressed EL devices which are capable of sustaining the injection of holes and electrons, but are themselves incapable of efficiently emitting light.

Useful fluorescent materials are those capable of being blended with the host material and fabricated into thin films satisfying the thickness ranges described above forming the luminescent zones of the EL devices of this invention. While crystalline host materials do not lend themselves to thin film formation, the limited amounts of fluorescent materials present in the host materials permits the use of fluorescent materials which are alone incapable of thin film formation. Preferred fluorescent materials are those which form a common phase with the host material. Fluorescent dyes constitute a preferred class of fluorescent materials, since dyes lend themselves to molecular level distribution in the host material. Although any convenient technique for dispersing the fluorescent dyes in the host materials can be undertaken, preferred fluorescent dyes are those which can be vacuum vapor deposited along with the host materials. Assuming other criteria, noted above, are satisfied, fluorescent laser dyes are recognized to be particularly useful fluorescent materials for use in the organic EL devices of this invention.

One preferred class of fluorescent dyes are fluorescent coumarin dyes. Among specifically preferred fluorescent coumarin dyes are those satisfying formula IV:

(IV)

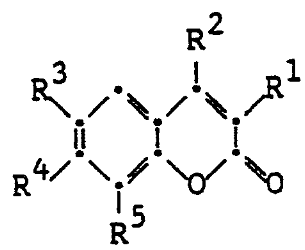

where
$R^1$ is chosen from the group consisting of hydrogen, carboxy, alkanoyl, alkoxycarbonyl, cyano, aryl, and a heterocylic aromatic group,
$R^2$ is chosen from the group consisting of hydrogen, alkyl, haloalkyl, carboxy, alkanoyl, and alkoxycarbonyl,
$R^3$ is chosen from the group consisting of hydrogen and alkyl,
$R^4$ is an amino group, and
$R^5$ is hydrogen, or
$R^1$ and $R^2$ together form a fused carbocyclic ring, and/or
the amino group forming $R^4$ completes with at least one of $R^3$ and $R^5$ a fused ring.

The alkyl moieties in each instance contain from 1 to 5 carbon atoms, preferably 1 to 3 carbon atoms. The aryl moieties are preferably phenyl groups. The fused carbocyclic rings are preferably five, six, or seven membered rings. The heterocyclic aromatic groups contain 5 or 6 membered heterocyclic rings containing carbon atoms and one or two heteroatoms chosen from the group consisting of oxygen, sulfur, and nitrogen. The amino group can be a primary, secondary, or tertiary amino group. When the amino nitrogen completes a fused ring with an adjacent substituent, the ring is preferably a five or six membered ring. For example, $R^4$ can with one adjacent substituent ($R^3$ or $R^5$) complete a pyran ring or with both adjacent substituents ($R^3$ and $R^5$) complete a julolidine ring.

The following are illustrative fluorescent coumarin dyes known to be useful as laser dyes:

FD-1 7-Diethylamino-4-methylcoumarin

FD-2 4,6-Dimethyl-7-ethylaminocoumarin

FD-3 4-Methylumbelliferone

FD-4 3-(2'-Benzothiazolyl)-7-diethylaminocoumarin

FD-5 3-(2'-Benzimidazolyl)-7-N,N-diethylamino-coumarin

FD-6 7-Amino-3-phenylcoumarin

FD-7 3-(2'-N-Methylbenzimidazolyl)-7-N,N-diethyl-aminocoumarin

FD-8 7-Diethylamino-4-trifluoromethylcoumarin

FD-9 2,3,5,6-1H,4H-Tetrahydro-8-methylquinolazino[9,9a,1-gh]coumarin

FD-10 Cyclopenta[c]julolindino[9,10-3]-11H-pyran-11-one

FD-11 7-Amino-4-methylcoumarin

FD-12 7-Dimethylaminocyclopenta[c]coumarin

FD-13 7-Amino-4-trifluoromethylcoumarin

FD-14 7-Dimethylamino-4-trifluoromethylcoumarin

FD-15 1,2,4,5,3H,6H,10H-Tetrahydro-8-trifluoromethyl[1]benzopyrano[9,9a,1-gh]quinolizin-10-one

FD-16 4-Methyl-7-(sulfomethylamino)coumarin sodium salt

FD-17 7-Ethylamino-6-methyl-4-trifluoromethylcoumarin

FD-18 7-Dimethylamino-4-methylcoumarin

FD-19 1,2,4,5,3H,6H,10H-Tetrahydro-carbethoxy-[1]benzopyrano[9,9a,1-gh]quinolizino-10-one

FD-20 9-Acetyl-1,2,4,5,3H,6H,10H-tetrahydro[1]-benzopyrano[9,9a,1-gh]quinolizino-10-one

FD-21 9-Cyano-1,2,4,5,3H,6H,10H-tetrahydro[1]-benzopyrano[9,9a,1-gh]quinolizino-10-one

FD-22 9-(t-Butoxycarbonyl)-1,2,4,5,3H,6H,10H-tetrahydro[1]benzopyrano[9,9a,1-gh]quinolizino-10-one

FD-23 4-Methylpiperidino[3,2-g]coumarin

FD-24 4-Trifluoromethylpiperidino[3,2-g]coumarin

FD-25 9-Carboxy-1,2,4,5,3H,6H,10H-tetrahydro[1]-benzopyrano[9,9a,1-gh]quinolizino-10-one

FD-26 N-Ethyl-4-trifluoromethylpiperidino[3,2-g]-coumarin

Another preferred class of fluorescent dyes are fluorescent 4-dicyanomethylene-4H-pyrans and 4-dicyanomethylene-4H-thiopyrans, hereinafter referred to as fluorescent dicyanomethylenepyran and thiopyran dyes. Preferred fluorescent dyes of this class are those satisfying formula (V):

(V)

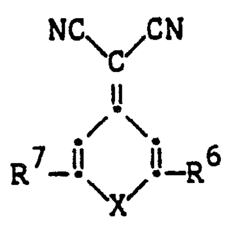

wherein
X represents oxygen or sulfur;
$R^6$ represents a 2-(4-aminostyryl) group; and
$R^7$ represents a second $R^6$ group, an alkyl group, or an aryl group.

Although X most conveniently represents oxygen or sulfur, it is appreciated that higher atomic number chalcogens should provide similar, though bathochromically shifted, response. The amino group can be a primary, secondary, or tertiary amino group. In one specifically preferred form the amino group can form at least one additional fused ring with the styryl phenyl ring. For example, the styryl phenyl ring and the amino group can together form a julolidine ring or the amino group can form an five or six membered ring fused with the styryl phenyl ring. The alkyl group forming $R^7$ typically contains from 1 to 5 carbon atoms, preferably 1 to 3 carbon atoms. The aryl group forming $R^7$ is preferably phenyl. When both $R^6$ and $R^7$ form a 2-(4-aminostyryl) group, the groups can be the same or different, but symmetrical compounds are more conveniently synthesized.

The following are illustrative fluorescent dicyanomethylenepyran and thiopyran dyes:

| | |
|---|---|
| FD-27 | 4-(Dicyanomethylene)-2-methyl-6-(p-dimethylaminostyryl)-4H-pyran |
| FD-28 | 4-(Dicyanomethylene)-2-methyl-6-[2-(9-julolidyl)ethenyl]-4H-pyran |
| FD-29 | 4-(Dicyanomethylene)-2-phenyl-6-[2-(9-julolidyl)ethenyl]-4H-pyran |
| FD-30 | 4-(Dicyanomethylene)-2,6-[2-(9-julolidyl)ethenyl]-4H-pyran |
| FD-31 | 4-(Dicyanomethylene)-2-methyl-6-[2-(9-julolidyl)ethenyl]-4H-thiopyran |

Useful fluorescent dyes can also be selected from among known polymethine dyes, which include the cyanines, merocyanines, complex cyanines and merocyanines (i.e., tri-, tetra- and poly-nuclear cyanines and merocyanines), oxonols, hemioxonols, styryls, merostyryls, and streptocyanines.

The cyanine dyes include, joined by a methine linkage, two basic heterocyclic nuclei, such as azolium or azinium nuclei, for example, those derived from pyridinium, quinolinium, isoquinolinium, oxazolium, thiazolium, selenazolium, indazolium, pyrazolium, pyrrolium, indolium, 3H-indolium, imidazolium, oxadiazolium, thiadioxazolium, benzoxazolium, benzothiazolium, benzoselenazolium, benzotellurazolium, benzimidazolium, 3H- or 1H-benzoindolium, naphthoxazolium, naphthothiazolium, naphthoselenazolium, naphthotellurazolium, carbazolium, pyrrolopyridinium, phenanthrothiazolium, and acenaphthothiazolium quaternary salts.

Exemplary of the basic heterocyclic nuclei are those satisfying Formulae VI and VII.

(VI)

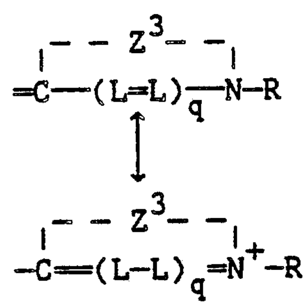

(VII)

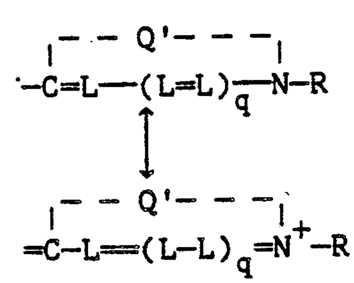

where
$Z^3$ represents the elements needed to complete a cyclic nucleus derived from basic heterocyclic nitrogen compounds such as oxazoline, oxazole, benzoxazole, the naphthoxazoles (e.g., naphth[2,1-d]oxazole, naphth[2,3-d]oxazole, and naphth[1,2-d]oxazole), oxadiazole, thiazoline, thiazole, benzothiazole, the naphthothiazoles (e.g., naphtho[2,1-d]thiazole), the thiazoloquinolines (e.g., thiazolo[4,5-b]quinoline), phenanthrothiazole, acenaphthothiazole, thiadioxazole, selenazoline, selenazole, benzoselenazole, the naphthoselenazoles (e.g., naphtho[1,2-d]selenazole), benzotellurazole, naphthotellurazoles (e.g., naptho[1,2-d]-tellurazole), imidazoline, imidazole, benzimidazole, the naphthimidazoles (e.g., naphth[2,3-d]imidazole), 2- or 4-pyridine, 2- or 4-quinoline, 1- or 3-isoquinoline, benzoquinoline, 3H-indole, 1H- or 3H-benzoindole, and pyrazole, which nuclei may be substituted on the ring by one or more of a wide variety of substituents such as hydroxy, the halogens (e.g., fluoro, chloro, bromo, and iodo), alkyl groups or substituted alkyl groups (e.g., methyl, ethyl, propyl, isopropyl, butyl, octyl, dodecyl, octadecyl, 2-hydroxyethyl, 3-sulfopropyl, carboxymethyl, 2-cyanoethyl, and trifluoromethyl), aryl groups or substituted aryl groups (e.g., phenyl, 1-naphthyl, 2-naphthyl, 4-sulfophenyl, 3-carboxyphenyl, and 4-biphenylyl), aralkyl groups (e.g., benzyl and phenethyl), alkoxy groups (e.g., methoxy, ethoxy, and isopropoxy), aryloxy groups (e.g., phenoxy and 1-naphthoxy), alkylthio groups (e.g., methylthio and ethylthio), arylthio groups (e.g., phenylthio, p-tolylthio, and 2-naphthylthio), methylenedioxy, cyano, 2-thienyl, styryl, amino or substituted amino groups (e.g., anilino, dimethylamino, diethylamino, and morpholino), acyl groups, (e.g., formyl, acetyl, benzoyl, and benzenesulfonyl);

Q′ represents the elements needed to complete a cyclic nucleus derived from basic heterocyclic nitrogen compounds such as pyrrole, indole, carbazole, benzindole, pyrazole, indazole, and pyrrolopyridine;

R represents alkyl groups, aryl groups, alkenyl groups, or aralkyl groups, with or without substituents, (e.g., carboxy, hydroxy, sulfo, alkoxy, sulfato, thiosulfato, phosphono, chloro, and bromo substituents);

L is in each occurrence independently selected to represent a substituted or unsubstituted methine group-e.g., $-CR^8=$ groups, where $R^8$ represents hydrogen when the methine group is unsubstituted and most commonly represents alkyl of from 1 to 4 carbon atoms or phenyl when the methine group is substituted; and

q is 0 or 1.

Cyanine dyes can contain two heterocyclic nuclei of the type shown in Formula VI joined by a methine linkage containing an uneven number of methine groups or can contain a heterocyclic nucleus according to each of Formulae VI and VII joined by a methine linkage containing an even number of methine groups, where the methine groups can take the form $-CR^8=$ as described above. The greater the number of the methine groups linking nuclei in the polymethine dyes in general and the cyanine dyes in particular the longer the absorption wavelengths of the dyes. For example, dicarbocyanine dyes (cyanine dyes containing five methine groups linking two basic heterocyclic nuclei) exhibit longer absorption wavelengths than carbocyanine dyes (cyanine dyes containing three methine groups linking two basic heterocyclic nuclei) which in turn exhibit longer absorption wavelengths than simple cyanine dyes (cyanine dyes containing a single methine group linking two basic heterocyclic nuclei). Carbocyanine and dicarbocyanine dyes are longer wavelength dyes while simple cyanine dyes are typically yellow dyes, but can exhibit absorption maxima up to about 550 nm in wavelength with proper choice of nuclei and other components capable of bathochromically shifting absorption.

Preferred polymethine dyes, particularly cyanine dyes, for use as fluorescent dyes are so-called rigidized dyes. These dyes are constructed to restrict the movement of one nucleus in relation to another. This avoids radiationless, kinetic dissipation of the excited state energy. One approach to rigidizing the dye structure is to incorporate a separate bridging group providing a separate linkage in addition to the methine chain linkage joining the terminal nuclei of the dye. Bridged polymethine dyes are illustrated by Brooker et al U.S. Patent 2,478,367, Brooker U.S. Patent 2,479,152, Gilbert U.S. Patent 4,490,463, and Tredwell et al, "Picosecond Time Resolved Fluorescence Lifetimes of the Polymethine and Related Dyes", Chemical Physics, Vol. 43 (1979) pp. 307-316.

The methine chain joining polymethine dye nuclei can be rigidized by including the methine chain as part of a cyclic nucleus joining the terminal basic nuclei of the dye. One of the techniques for both rigidizing and bathochromically shifting the absorption maxima of polymethine dyes in general and cyanine dyes in particular is to include in the methine linkage an oxocarbon bridging nucleus. Exemplary oxocarbon bridging nuclei can take any of the forms indicated by Formula VIII.

(VIII)

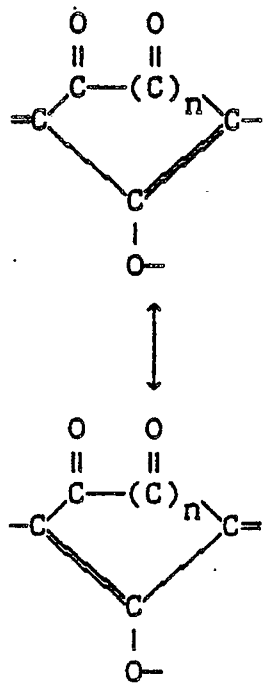

wherein n is the integer 0, 1, or 2.

Merocyanine dyes link one of the cyanine dye type basic heterocyclic nuclei described above to an acidic keto methylene nucleus through a methine linkage as described above, but containing zero, two, or a higher even number of methine groups. Zero methine dyes, those containing no methine groups in the linkage between nuclei, exhibit a double bond linkage between the nuclei in one resonance form and a single bound linkage in another resonance form. In either resonance form the linkage sites in the nuclei are formed by methine groups forming a part of each nucleus. Zero methine polymethine dyes are yellow dyes.

Exemplary acidic nuclei are those which satisfy Formula IX.

(IX)

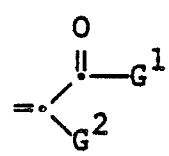

where

$G^1$ represents an alkyl group or substituted alkyl group, an aryl or substituted aryl group, an aralkyl group, an alkoxy group, an aryloxy group, a hydroxy group, an amino group, or a substituted amino group, wherein exemplary substituents can take the various forms noted in connection with Formulae VI and VII;

$G^2$ can represent any one of the groups listed for $G^1$ and in addition can represent a cyano group, an alkyl, or arylsulfonyl group, or a group represented by $-\underset{\underset{O}{\|}}{C}-G^1$,

or $G^2$ taken together with $G^1$ can represent the elements needed to complete a cyclic acidic nucleus such as those derived from 2,4-oxazolidinone (e.g., 3-ethyl-2,4-oxazolidindione), 2,4-thiazolidindione (e.g., 3-methyl-2,4-thiazolidindione), 2-thio-2,4-oxazolidindione (e.g., 3-phenyl-2-thio-2,4-oxazolidindione), rhodanine, such as 3-ethylrhodanine, 3-phenylrhodanine, 3-(3-dimethylaminopropyl)rhodanine, and 3-carboxymethylrhodanine, hydantoin (e.g., 1,3-diethylhydantoin and 3-ethyl-1-phenylhydantoin), 2-thiohydantoin (e.g., 1-ethyl-3-phenyl-2-thiohydantoin, 3-heptyl-1-phenyl-2-thiohydantoin, and arylsulfonyl-2-thiohydantoin), 2-pyrazolin-5-one, such as 3-methyl-1-phenyl-2-pyrazolin-5-one, 3-methyl-1-(4-carboxybutyl)-2-pyrazolin-5-one, and 3-methyl-2-(4-sulfophenyl)-2-pyrazolin-5-one, 2-isoxazolin-5-one (e.g., 3-phenyl-2-isoxazolin-5-one), 3,5-pyrazolidindione (e.g., 1,2-diethyl-3,5-pyrazolidindione and 1,2-diphenyl-3,5-pyrazolidindione), 1,3-indandione, 1,3-dioxane-4,6-dione, 1,3-cyclohexanedione, barbituric acid (e.g., 1-ethylbarbituric acid and 1,3-diethylbarbituric acid), and 2-thiobarbituric acid (e.g., 1,3-diethyl-2-thiobarbituric acid and 1,3-bis(2-methoxyethyl)-2-thiobarbituric acid).

Useful hemicyanine dyes are essentially similar to the merocyanine dyes described above, differing

only in substituting for the keto methylene group of Formula IX the group shown below in Formula X.

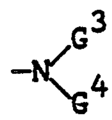

where

$G^3$ and $G^4$ may be the same or different and may represent alkyl, substituted alkyl, aryl, substituted aryl, or aralkyl, as illustrated for ring substituents in Formula VI or $G^3$ and $G^4$ taken together complete a ring system derived from a cyclic secondary amine, such as pyrrolidine, 3-pyrroline, piperidine, piperazine (e.g., 4-methylpiperazine and 4-phenylpiperazine), morpholine, 1,2,3,4-tetrahydroquinoline, decahydroquinoline, 3-azabicyclo[3,2,2]nonane, indoline, azetidine, and hexahydroazepine.

Useful hemioxonol dyes exhibit a keto methylene nucleus as shown in Formula IX and a nucleus as shown in Formula X joined by a methine linkage as previously described containing one or a higher uneven number of methine groups.

Useful merostyryl dyes exhibit a keto methylene nucleus as shown in Formula IX and a nucleus as shown in Formula XI joined by a methine linkage as described above containing one or a higher uneven number of methine groups.

(XI)

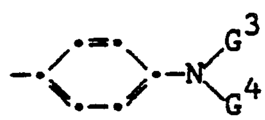

where

$G^3$ and $G^4$ are as previously defined.

The longer wavelength cyanine, merocyanine, hemicyanine, hemioxonol, and merostyryl dyes described above are intended to be illustrative of the simpler structural forms of useful longer wavelength polymethine dyes. It is generally recognized that substituents can join the nuclei and methine linkages to form additional cyclic structures. Further, the dyes can contain three or more nuclei. For example, by substituting a merocyanine dye in methine linkage with a second basic heterocyclic nucleus of the cyanine dye type an allopolar cyanine dye can be formed. Further, the various substituents not forming a part of the dye chromophore can be varied as desired to tailor dye physical properties, particularly hydrophobicity and hydrophillicity, to suit the particular film forming components employed. By choosing as the aliphatic moieties of the dyes hydrocarbon groups having more carbon atoms (e.g., from about 6 to 20 carbon atoms) the dyes can be rendered more oleophilic while hydrocarbon groups containing fewer numbers of carbon atoms (e.g., 1 to 5 carbon atoms) and particularly those bearing polar substituents render the dyes more hydrophilic. The aromatic moieties of the dyes typically contain from 6 to 10 carbon atoms.

The following are illustrative of polymethine dyes capable of maximum light absorption at shorter (<550 nm) wavelengths:

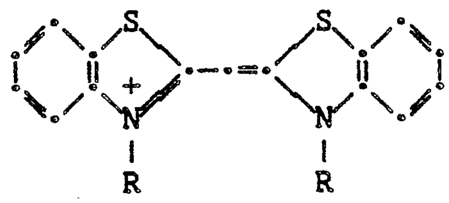 $X^-$

| | R | $X^-$ |
|---|---|---|
| FD-32 | $-C_{16}H_{33}$ | $Cl^-$ |
| FD-33 | $-C_{18}H_{37}$ | $PTS^-$ |
| FD-34 | $-CH_2CH{=}CH_2$ | $Cl^-$ |

PTS = p-toluene sulfonate

FD-35

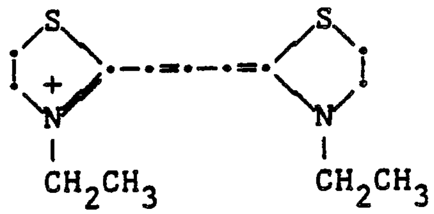

$Cl^-$

FD-36

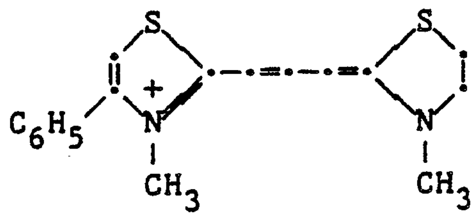

$Cl^-$

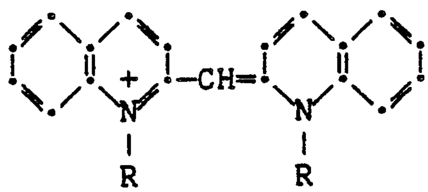

$X^-$

| | R | $X^-$ |
|---|---|---|
| FD-37 | $-CH_2CH_3$ | $ClO_4^-$ |
| FD-38 | $-C_4H_9$ | $ClO_4^-$ |
| FD-39 | $-C_5H_{11}$ | $BF_4^-$ |

FD-40

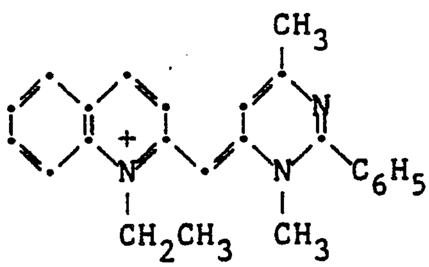

$Cl^-$

FD-41

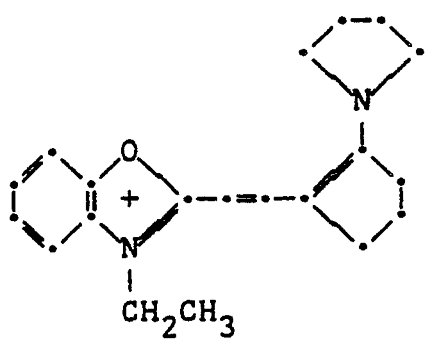

$ClO_4^-$

FD-42

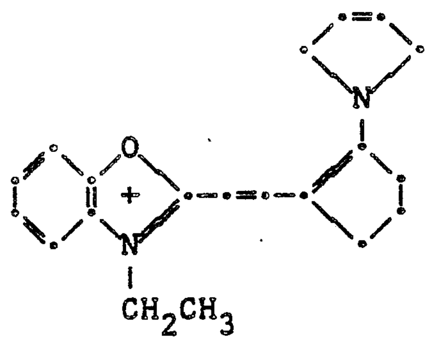

$ClO_4^-$

FD-43

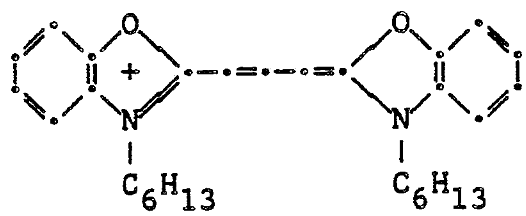

$Cl^-$

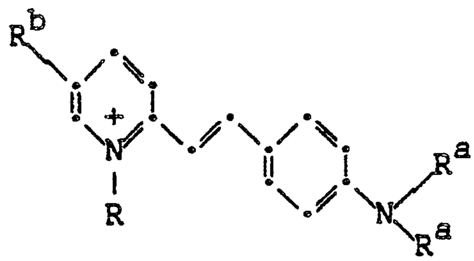

$Cl^-$

| | $R^a$ | R | $R^b$ |
|---|---|---|---|
| FD-44 | $-CH_3$ | $-CH_3$ | H |
| FD-45 | $-CH_3$ | $-CH_3$ | $-C_2H_3$ |
| FD-46 | $-C_3H_7$ | $-CH_3$ | H |

DF-47

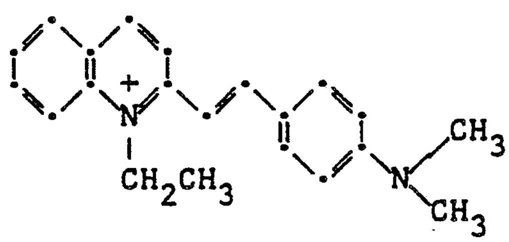

$I^-$

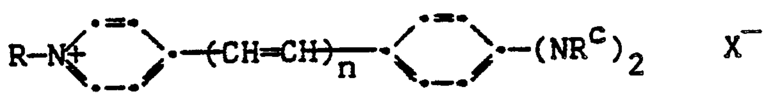

| | n | R | $R^c$ | $X^-$ |
|---|---|---|---|---|
| FD-48 | 1 | $-CH_3$ | $C_2H_5$ | PTS- |
| FD-49 | 1 | $(CH_2)_3SO_3-$ | $C_5H_{11}$ | — |
| FD-50 | 1 | $(CH_2)_4SO_3-$ | $C_5H_{11}$ | — |
| FD-51 | 2 | $(CH_2)_5SO_3-$ | $C_2H_5$ | — |

FD-52 3,3'-Ethylenethiacyanine p-toluenesulfonate

FD-53 1',3-Ethylenethia-2'-cyanine chloride

FD-54 1,1'-Ethylene-2,2'-cyanine chloride

FD-55 3,3'-Ethyleneoxacyanine chloride

FD-56 1,1'-Diethyl-3,3'-Ethylenebenzimidazolocyanine p-toluenesulfonate

FD-57 1,1'-Diethyl-3,3'-methylenebenzimidazolocyanine chloride

FD-58 1,1'-Ethylenecyanine chloride

FD-59 1,1'-Methylenecyanine chloride

FD-60 5,5',6,6'-Tetrachloro-1,1'-diethyl-3,3'-ethanediylbenzimidazolocyanine chloride

FD-61 5,5',6,6'-Tetrachloro-1,1'-ethanediyl-3,3'-dimethylbenzimidazolocyanine chloride

FD-62 Anhydro-5,5',6,6'-tetrachloro-1,1'-ethandiyl-3,3'-bis(3-sulfopropyl)benzimidazolocyanine hydroxide, sodium salt

FD-63 2,2'-Methanediylbis-(5,6-dichloro-1-methyl-benzimidazole

FD-64 5,5',6,6'-Tetrachloro-1,1'-dimethyl-3,3'-propanediylbenzimidazolocyanine p-toluenesulfonate

FD-65 5,5',6,6'-Tetrachloro-1,1'-dimethyl-3,3'-methanediylbenzimidazolocyanine p-toluenesulfonate

FD-66 5,5',6,6'-Tetrachloro-1,1'-ethanediyl-3,3'-bis(2,2,2-trifluoroethyl)benzimidazolocyanine p-toluenesulfonate

FD-67 5,5',6,6'-Tetrachloro-1,1'-ethanediyl-3,3',8-trimethylbenzimidazolocyanine p-toluenesulfonate

Many polymethine dyes are capable of maximum light absorption at longer visible (> 550 nm) wavelengths, with maximum fluorescence wavelengths generally lying in the red and near infrared portions of the spectrum. The following are illustrative of polymethine dyes capable of maximum light absorption at longer visible wavelengths:

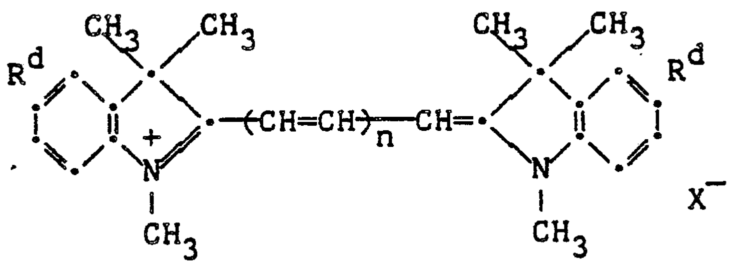

| | n | $R^d$ | $X^-$ |
|---|---|---|---|
| FD-68 | 1 | – | $BF_4^-$ |
| FD-69 | 2 | – | $PTS^-$ |
| FD-70 | 3 | – | $BF_4^-$ |
| FD-71 | 3 | $-(CH=CH)_2-$ | $ClO_4^-$ |

FD-72

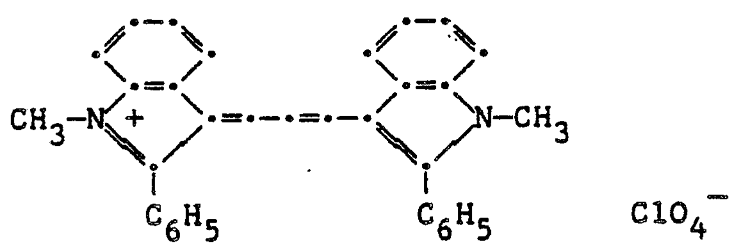

FD-73

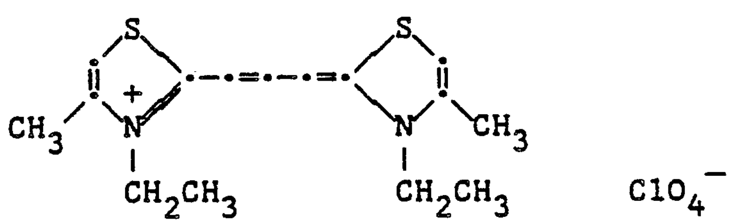

FD-74

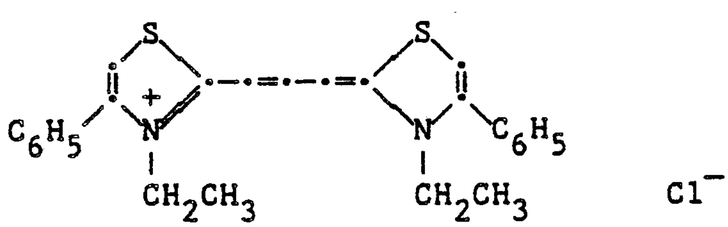

FD-75

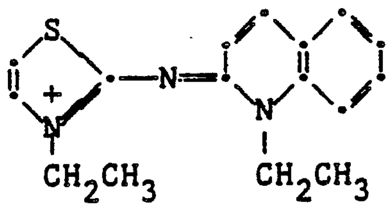

$Cl^-$

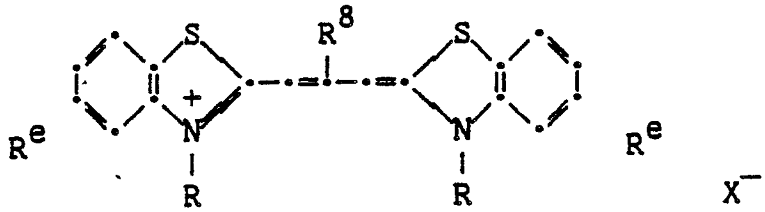

| | R | $R^8$ | $R^e$ | $X^-$ |
|---|---|---|---|---|
| FD-76 | $-C_4H_9$ | $-H$ | — | $Cl^-$ |
| FD-77 | $-C_{18}H_{37}$ | $-H$ | — | $PTS^-$ |
| FD-78 | $-C_4H_9$ | $-CH_3$ | — | $Cl^-$ |
| FD-79 | $-C_5H_{11}$ | $-CH_3$ | — | $Cl^-$ |
| FD-80 | $-i-C_3H_7$ | $-CH_3$ | — | $Cl^-$ |
| FD-81 | $-C_3H_7$ | $-C_2H_5$ | — | $Cl^-$ |
| FD-82 | $-C_2H_5$ | $-C_2H_5$ | — | $C_3F_7COO^-$ |
| FD-83 | $-C_2H_5$ | $-C_6H_{11}$ (cyclohexyl) | $-(CH{=}CH)_2$ | $Cl^-$ |
| FD-84 | $C_2H_5$ | $-C_{15}H_{31}$ | $-(CH{=}CH)_2$ | $Cl^-$ |

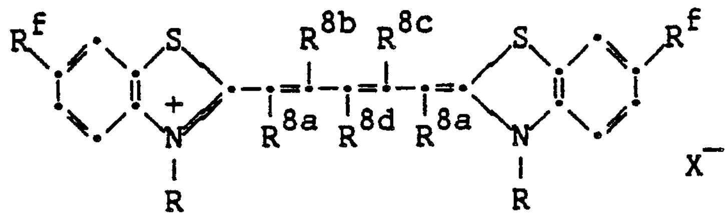

| | R | $R^{8a}$ | $R^{8b}$ | $R^{8c}$ | $R^{8d}$ | $R^f$ | $X^-$ |
|---|---|---|---|---|---|---|---|
| FD-85 | $-CH_2CH_3$ | H | H | H | H | H | $Cl^-$ |
| FD-86 | $-CH_2CH_3$ | H | H | H | H | $-OCH_3$ | $PTS^-$ |
| FD-87 | $-CH_2CH_3$ | H | H | H | $-CH_3$ | H | $ClO_4^-$ |
| FD-88 | $-CH_2CH_3$ | H | $CH_2-C(CH_3)_2-CH_2$ | | H | H | $ClO_4^-$ |

| | | | | | | |
|---|---|---|---|---|---|---|
| FD-89 | $CH_2CH_2CH_2$ | H | H | H | H | $PTS^-$ |
| FD-90 | $CH_2$——$CH_2$ | $CH_2-C-CH_2$ <br> $(CH_3)_2$ | | H | H | $PTS^-$ |

FD-91

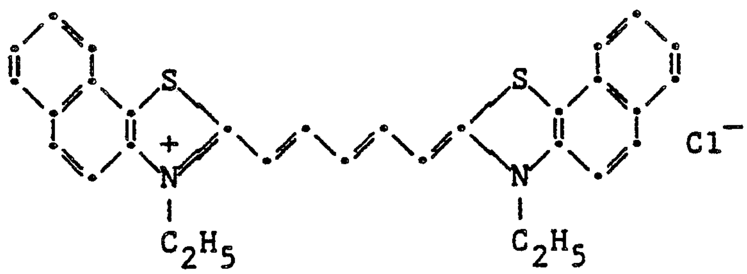

FD-92

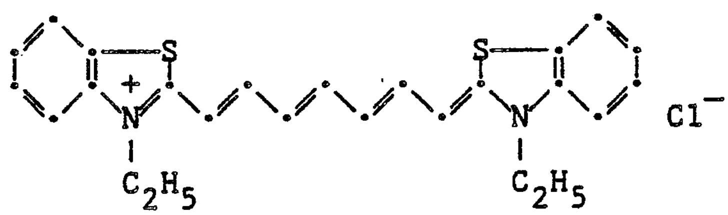

FD-93

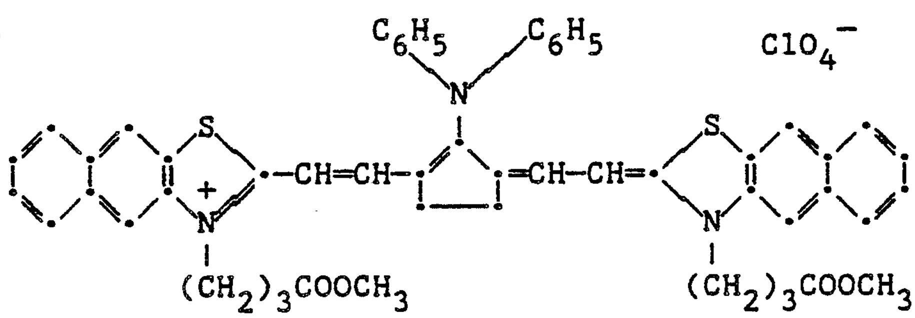

FD-94

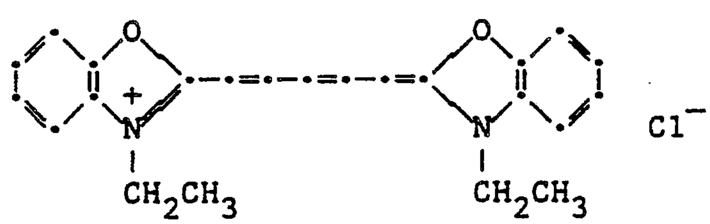

FD-95

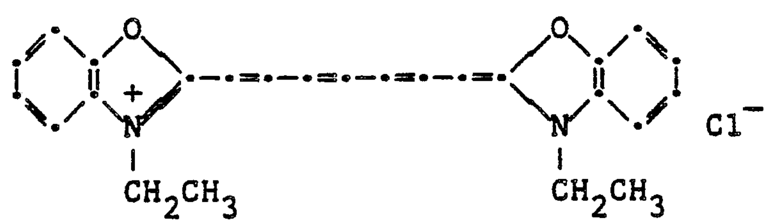

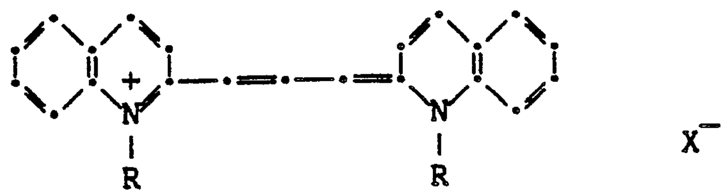

| | R | $X^-$ |
|---|---|---|
| FD-96 | $-CH_2CH_2C_6H_5$ | $BF_4^-$ |
| FD-97 | $-CH_2CH_3$ | $Cl^-$ |

FD-98

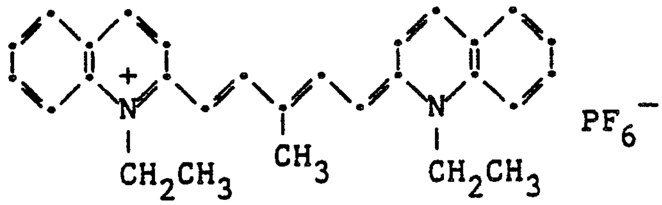

FD-99

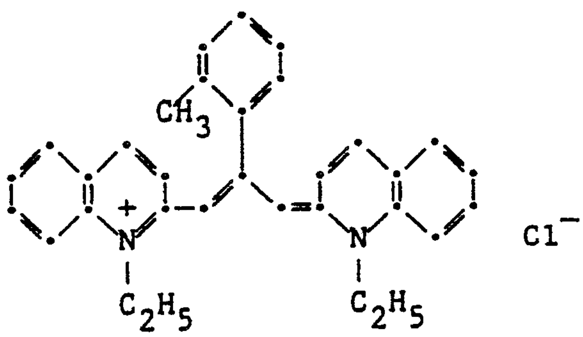

FD-100

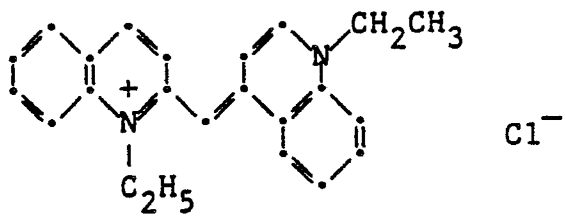

FD-101

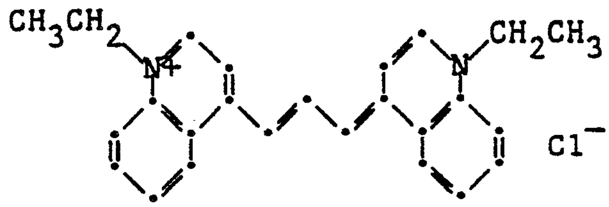

FD-102

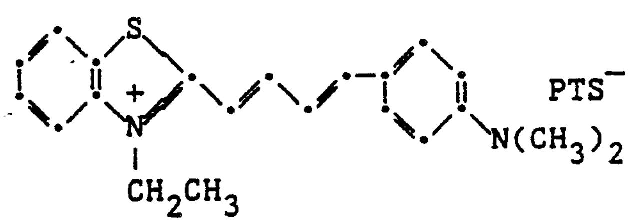

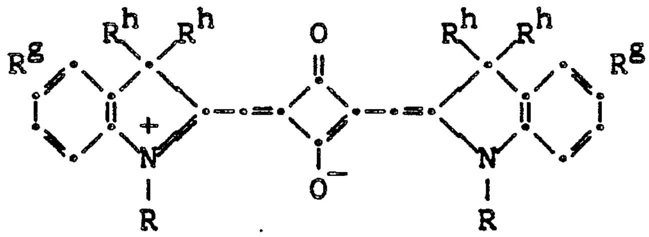

| | $R^h$ | R | $R^g$ |
|---|---|---|---|
| FD-103 | $-CH_3$ | $-CH_3$ | – |
| FD-104 | $-CH_3$ | $-CH_3$ | $-(CH=CH)_2$ |
| FD-105 | $-CH_3$ | $-C_6H_5$ | – |
| FD-106 | $-CH_3$ | $-CH_2$ 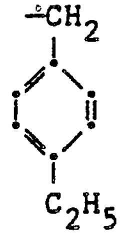 | – |
| FD-107 | 2 adjacent $R^1 = -(CH_2)_5$ i.e., spirocyclohexyl | | |

FD-108

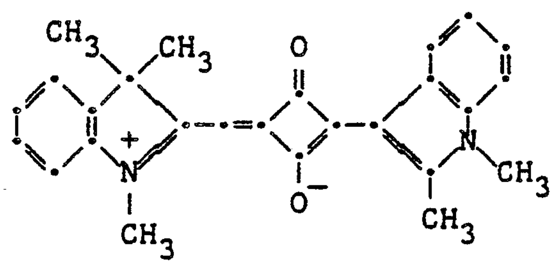

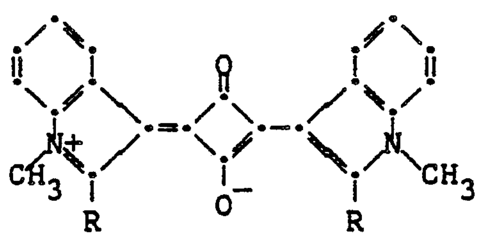

FD-109 $R = C_6H_5$

FD-110 $R = -C_{10}H_7$, i.e. α-naphthyl

FD-111

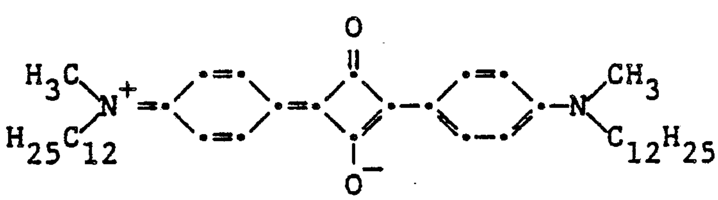

FD-112

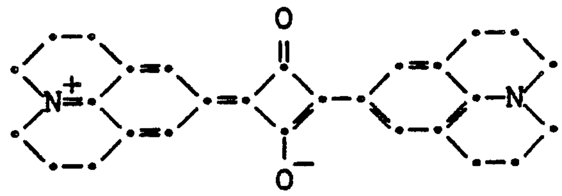

FD-113

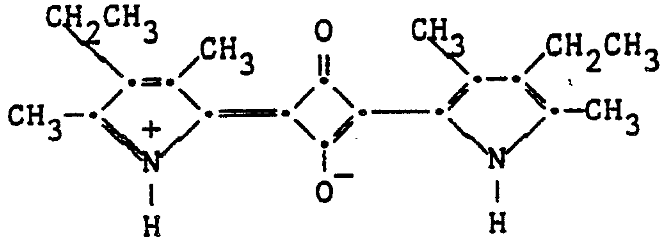

Another useful class of fluorescent dyes are 4-oxo-4H-benz-[d,e]anthracenes, hereinafter referred to as oxobenzanthracene dyes. Dyes of this class and their preparations are disclosed in Goswami et al U.S. Patent 4,812,393. Preferred fluorescent oxobenzanthracene dyes are those represented by formula XII:

(XII)

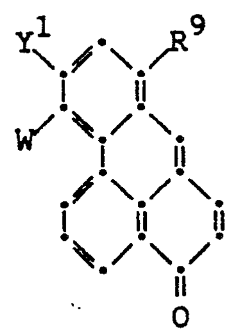

In this structure, $R^9$ is hydrogen, substituted or unsubstituted alkyl (preferably of 1 to 12 carbon atoms, e.g. methyl, ethyl, isopropyl, benzyl, phenethyl, etc.), substituted or unsubstituted hydroxyalkyl (preferably of 1 to 12 carbon atoms, e.g. hydroxymethyl, 2-hydroxyethyl, 2-hydroxyisopropyl, etc.), or substituted or unsubstituted alkoxycarbonyl (preferably of 2 to 12 carbon atoms, e.g. methoxycarbonyl, ethoxycarbonyl, n-propoxycarbonyl, etc.). Preferably, $R^9$ is hydrogen, substituted or unsubstituted alkyl or substituted or unsubstituted alkoxycarbonyl, and more preferably, it is substituted or unsubstituted alkoxycarbonyl.

W is hydrogen or an electron withdrawing group as that term is understood in the art (i.e. a group generally having a positive Hammett sigma value as determined by standard procedures). Particularly useful electron withdrawing groups include, but are not limited to, halo (e.g. fluoro, chloro, bromo), cyano, carboxy, acyl, substituted or unsubstituted arylsulfonyl (preferably of 6 to 10 carbon atoms, e.g. phenylsulfonyl, tolylsulfonyl, etc.), substituted or unsubstituted alkylsulfonyl (preferably of 1 to 6 carbon atoms, e.g. methylsulfonyl, ethylsulfonyl, etc.), substituted and unsubstituted dialkylphosphinyl (preferably where each alkyl group independently has 1 to 10 carbon atoms, e.g. methyl, ethyl, butyl, decyl, etc.) and substituted or unsubstituted dialkyl phosphono (preferably where each alkyl group independently has 1 to 10 carbon atoms as defined above). Preferably, W is hydrogen or halo.

$Y^1$ is hydrogen, or a group comprised of a heteroatom having a lone pair of electrons or a negative charge with an associated cation, e.g. hydroxy, mercapto or amino ($-NR''R'''$). $R''$ and $R'''$ are independently substituted or unsubstituted alkyl (preferably of 1 to 10 carbons, e.g., methyl, ethyl, decyl, etc.), substituted or unsubstituted aryl (preferably of 6 to 10 carbons, e.g., phenyl, naphthyl, etc.), or $R''$ and $R'''$, taken together, can represent the atoms necessary to complete a substituted or unsubstituted heterocyclic ring (preferably of 5 to 10 carbon, nitrogen or oxygen atoms, e.g. a morpholino, pyrrolidinyl, pyridyl, piperidino, etc. ring). $Y^1$ can also be substituted or unsubstituted alkoxy (preferably of 1 to 10 carbon atoms, e.g. methoxy, ethoxy, 2-chloro-1-propoxy, etc.), substituted or unsubstituted carbamyloxy

(-O-$\overset{O}{\overset{\|}{C}}$-NR″R‴), wherein R″ and R‴ are defined above, -O$^-$ M$^+$ or -S$^-$ M$^+$, wherein M$^+$ is a monovalent cation, e.g. Na$^+$, K$^+$, Li$^+$, $NH_4{}^+$, etc. Preferably $Y^1$ is hydroxy or -O$^-$M$^+$.

| | $R^9$ | W | $Y^1$ |
|---|---|---|---|
| FD-114 | Methyl | Hydrogen | Hydroxy |
| FD-115 | Methyl | Hydrogen | -O$^-$Na$^+$ |
| FD-116 | Methyl | Chloro | Hydroxy |
| FD-117 | Methyl | Chloro | -O$^-$Na$^+$ |
| FD-118 | Methyl | Chloro | N-methyl-N-phenylcarbamyloxy |
| FD-119 | Methyl | Hydrogen | Pyrrolidinyl |
| FD-120 | Butoxycarbonyl | Hydrogen | Hydroxy |
| FD-121 | Butoxycarbonyl | Hydrogen | -O$^-$Na$^+$ |
| FD-122 | Butoxycarbonyl | Chloro | -O$^-$Na$^+$ |

The oxobenzanthracene dyes illustrated above can have one or more substituents other than those specifically illustrated in the structure as long as the substituents do not adversely affect the fluorescence of the compound, such as alkyl (e.g., alkyl of 1 to 5 carbon atoms), aryl (e.g., phenyl), and other groups.

The oxobenzanthracene dyes can be prepared generally using the following procedure. The details of several preparations are provided in APPENDIX I below. The general preparatory procedure includes: (1) preparation of a dihydrophenalenone by the procedure described by Cooke et al, Australian J. Chem., 11, pp. 230-235 (1958), (2) preparation of the lithium enolate of the dihydrophenalenone, (3) reaction of the lithium enolate with the appropriate phosphonium iodide reagent, and (4) reaction of this product with cupric chloride and lithium chloride to produce the chlorinated or unchlorinated dye.

Another useful class of fluorescent dyes are xanthene dyes. One particularly preferred class of xanthene dyes are rhodamine dyes. Preferred fluorescent rhodamine dyes are those represented by formula XIII:

(XIII)

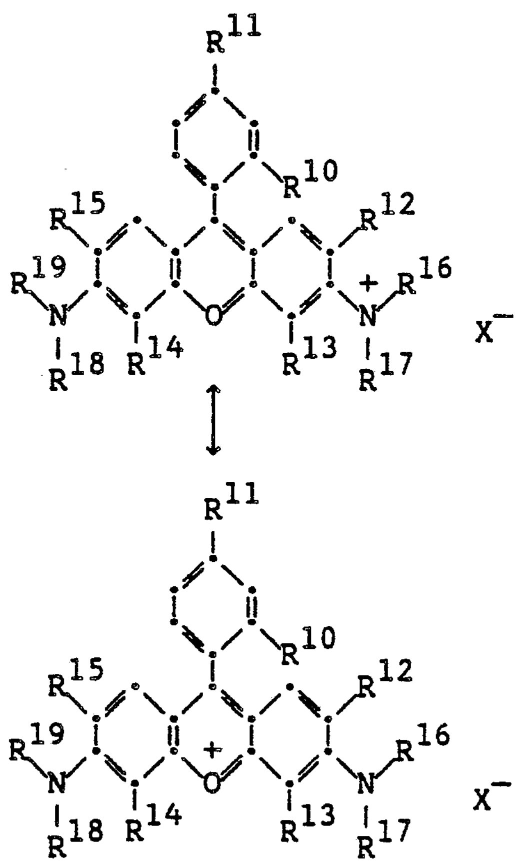

where

$R^{10}$ and $R^{11}$ are independently hydrogen, carboxyl, sulfonyl, alkanoyl, or alkoxycarbonyl groups;
$R^{12}$, $R^{13}$, $R^{14}$, and $R^{15}$ are hydrogen;
$R^{16}$, $R^{17}$, $R^{18}$, and $R^{19}$ are alkyl groups;
and
$X^-$ is an anion; or
any one of or all of following substituent pairs: $R^{12}$ and $R^{16}$, $R^{13}$ and $R^{17}$, $R^{14}$ and $R^{18}$, and $R^{15}$ and $R^{19}$, complete a five or six membered ring containing nitrogen as the sole heteroatom.

The alkyl moieties in each instance contain from 1 to 5 carbon atoms, preferably 1 to 3 carbon atoms. When substituent pairs complete a fused ring, the ring can, for example, take the form of a pyran ring when a single fused ring including a formula nitrogen atom is formed or a julolidene ring (including a formula fused benzo ring) when two fused rings each including the same nitrogen atom of the formula are formed.

The following are illustrative of rhodamine dyes known to be useful laser dyes:

| | |
|---|---|
| FD-123 | [9-(o-Carboxyphenyl)-6-(diethylamino)-3H-xanthen-3-ylidene]diethyl ammonium chloride [a.k.a rhodamine B] |
| FD-124 | N-{6-[Diethylamino]-9-[2-(ethoxycarbonyl)phenyl]-3H-xanthen-3-ylidene}-N-ethylethanaminium perchlorate |
| FD-125 | Ethyl o-[6-(Ethylamino)-3-(ethylimino)-2,7-dimethyl-3H-xanthenyl]benzoate chloride |
| FD-126 | Ethyl o-[6-(ethylamino)-3-(ethylimino)-2,7-dimethyl-3H-xanthenyl]benzoate perchlorate |
| FD-127 | Ethyl o-[6-(ethylamino)-3-(ethylimino)-2,7-dimethyl-3H-xanthenyl]benzoate tetrafluoroborate |
| FD-128 | o-[6-(Ethylamino)-3-(ethylimino)-2,7-dimethyl-3H-xanthenyl]benzoic acid |
| FD-129 | o-(6-Amino-3-imino-3H-xanthenyl)benzoic acid hydrochloride |
| FD-130 | o-[6-(Methylamino)-3-(methylimino)-3H-xanthen-9-yl]benzoic acid perchlorate |
| FD-131 | Methyl o-(6-amino-3′-imino-3H-xanthen-9-yl)benzoate monohydrochloride |
| FD-132 | 8-(2,4-Disulfophenyl)-2,3,5,6,11,12,14,15-1H,4H,10H,13H-octahydroquinolizinol[9,9a,1-bc;9,9a,1-hi]xanthylium hydroxide inner salt |
| FD-133 | Sulforhodamine B |
| FD-134 | o-[6-(Dimethylamino)-3-(dimethylamino)-3H-xanthen-9-yl]benzoic acid perchlorate |

Another specifically preferred class of xanthene dyes are fluorescein dyes. Preferred fluorescein dyes are those represented by formula XIV:

(XIV)

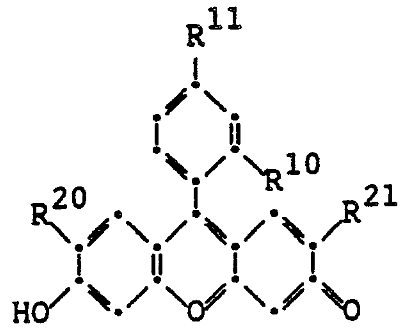

where
$R^{10}$ and $R^{11}$ are as previously defined and
$R^{20}$ and $R^{21}$ are hydrogen, alkyl, aryl, or halo substituents. Preferred alkyl groups contain from 1 to 5, optimally from 1 to 3 carbon atoms while phenyl is a preferred aryl group.

An illustrative fluorescein dye is

| | |
|---|---|
| FD-119 | 9-(o-Carboxyphenyl)-6-hydroxy-3H-xanthen-3-one |
| FD-120 | 9-(o-Carboxyphenyl)-2,7-dichloro-6-hydroxy-3H-xanthen-3-one |

Another useful group of fluorescent dyes are pyrylium, thiapyrylium, selenapyrylium, and telluropyrylium dyes. Dyes from the first three of these classes are disclosed by Light U.S. Patent 3,615,414 while dyes of the latter class are disclosed by Detty U.S. Patent 4,584,258. Since the latter two classes of dyes are bathochromically shifted toward the infrared the former two classes of dyes are preferred for achieving visible light emissions.

Illustrative preferred fluorescent pyrylium and thiapyrylium dyes are represented by formula XV:

(XV)

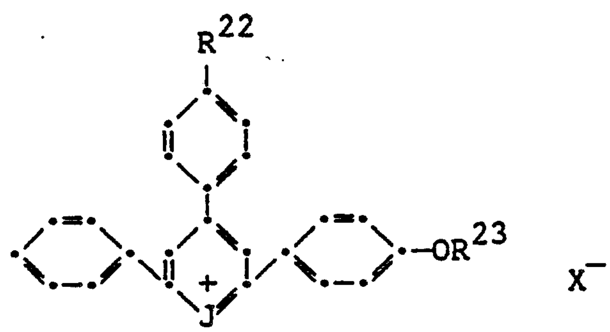

where
$R^{22}$ is hydrogen, methyl, or a tertiary amino group, optimally a $-NR^{23}R^{23}$ group;
$R^{23}$ is an alkyl group;
$X^-$ is an anion; and
J is oxygen or sulfur.
The alkyl group preferably contains from 1 to 5 carbon atoms and optimally from 1 to 3 carbon atoms. Illustrative pyrylium and thiapyrylium fluorescent dyes satisfying formula XV are the following:

| | |
|---|---|
| FD-135 | 4-(4-dimethylaminophenyl)-2-(4-methoxyphenyl)-6-phenylpyrylium perchlorate |
| FD-136 | 4,6-diphenyl-2-(4-ethoxyphenyl)-thiapyrylium p-toluenesulfonate |
| FD-137 | 2-(4-methoxyphenyl)-6-phenyl-4-(p-tolyl)-pyrylium tetrafluoroborate |

Another useful class of fluorescent dyes are fluorescent carbostyril dyes. These dyes are characterized

by a 2-quinolinol or isoquinolinol ring structure, often fused with other rings. The wavelength of maximum fluorescence generally increases with the presence of other fused rings. Typical of simple carbostyril dyes, which fluoresce in the blue portion of the spectrum, are the following:

| | |
|---|---|
| FD-138 | 7-Amino-4-methyl-2-quinolinol<br>[a.k.a. 7-amino-4-methylcarbostyril] |
| FD-139 | 7-Dimethylamino-2-hydroxy-4-methylquinoline<br>[a.k.a. 7-dimethylamino-4-methylcarbostyryl] |
| FD-140 | 3,3′-Bis[N-phenylisoquinoline] |

Examples are more complex fused ring carbostyril dyes are provided by Kadhim and Peters, "New Intermediates and Dyes for Synthetic Polymer Fibres Substituted Benzimidazolothioxanthenoisoquinolines for Polyester Fibres", JSDC, June 1974, pp. 199-201, and Arient et al, "Imidazole Dyes XX-Colouring Properties of 1,2-Napthooxylenebenzimidazole Derivatives", JSDC, June 1968, pp. 246-251. Illustrative of these more complex carbostyril dyes are the following:

| | |
|---|---|
| FD-141 | Benzimidazo[1,2-b]thioxantheno[2,1,9,d,e,f]isoquinolin-7-one and its stereo isomer<br>Benzimidazo[1,2-a]thioxantheno[2,1,9,d,e,f]isoquinolin-7-one |

Among other fused ring fluorescent dyes the perylene dyes, characterized by a dinapthylene nucleus. A variety of useful fluorescent perylene dyes are known, such as, for example those disclosed by Rademacher et al, "Soluble Perylene Fluorescent Dyes with Photostability", Chem. Ber., Vol. 115, pp. 2927-2934, 1982, and European Patent Application Publication No. 553,363A1, published July 7, 1982. One preferred perylene dye is illustrated by formula XVI:

(XVI)

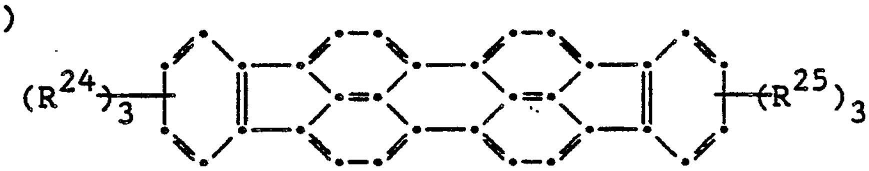

where

$R^{24}$ and $R^{25}$ are independently selected from the group consisting of alkyl, halo, and haloalkyl substituents. Preferred alkyl groups having from 1 to 5 carbon atoms, optimally from 1 to 3 carbon atoms.

Another preferred group of perylene dyes are the 3,4,9,10-perylenebis(dicarboximides), hereinafter referred to a perylenebis(dicarboximide) dyes. Preferred dyes of this class are represented by formula XVII:

(XVII)

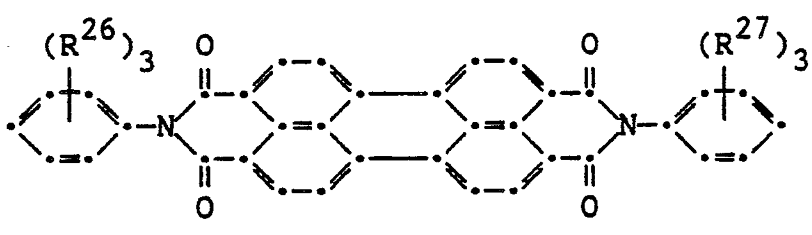

where

$R^{26}$ and $R^{27}$ are independently selected from the group consisting of alkyl, halo, and haloalkyl substituents. Preferred alkyl groups having from 1 to 5 carbon atoms, optimally from 1 to 3 carbon atoms.

Illustrative of preferred perylene dyes are the following:

| | |
|---|---|
| FD-142 | Perylene |
| FD-143 | 1,2-Bis(5,6-o-phenylenenapthalene) |
| FD-144 | N,N′-diphenyl-3,4,9,10-perylenebis(dicarboximide) |
| FD-145 | N,N′-di(p-tolyl)-3,4,9,10-perylenebis(dicarboximide) |
| FD-146 | N,N′-di(2,6-di-t-butyl)-3,4,9,10-perylenebis(dicarboximide) |

The foregoing listing of preferred fluorescent dyes useful in combination with the host materials, though lengthy, is recognized to be only exemplary of known fluorescent dyes, both in the classes specifically identified and in still other dye classes. For example, many other classes of known fluorescent dyes, such as acridine dyes; bis(styryl)benzene dyes; pyrene dyes; oxazine dyes; and phenyleneoxide dyes, sometimes referred to as POPOP dyes; are useful, specific illustrative dyes from these classes including the following:

| | |
|---|---|
| FD-147 | 9-Aminoacridine hydrochloride |
| FD-148 | p-Bis(o-methylstyryl)benzene |
| FD-149 | 2,2′-p-Phenylenebis(4-methyl-5-phenyloxazole) |
| FD-150 | 5,9-Diaminobenzo[a]phenoxazonium perchlorate |
| FD-151 | 5-Amino-9-diethylaminobenz[a]phenoxazonium perchlorate |
| FD-152 | 3,7-Bis(diethylamino)phenoxazonium perchlorate |
| FD-153 | 3,7-Bis(ethylamino)-2,8-dimethylphenoxazin-5-ium perchlorate |
| FD-154 | 9-Ethylamino-5-ethylimino-10-methyl-5H-benzo[a]phenoxazonium perchlorate |
| FD-155 | 8-Hydroxy-1,3,6-pyrene-trisulfonic acid trisodium salt |

Not only are there many available classes of fluorescent dyes to choose from, there are wide choices of individual dye properties within any given class. The absorption maxima and reduction potentials of individual dyes can be varied through the choice of substituents. As the conjugation forming the chromophore of the dye is increased the absorption maximum of a dye can be shifted bathochromically.

Emission maxima are bathochromic to the absorption maxima. Although the degree of bathochromic shifting can vary as a function of the dye class, usually the wavelength of maximum emission is from 25 to 125 nm bathochromically shifted as compared to the wavelength of maximum absorption. Thus, dyes which exhibit absorption maxima in the near ultraviolet in almost all cases exhibit maximum emissions in the blue portion of the spectrum. Dyes which exhibit absorption maxima in the blue portion of the spectrum exhibit emission maxima in the green portion of the spectrum, and, similarly, dyes with absorption maxima in the red portion of the spectra tend to exhibit emission maxima in the near infrared portion of the spectrum.

In one form of the invention the material forming the luminescent zone can be one uniform layer interposed between and contacting both the cathode and the hole injection zone of the EL device. As an alternative construction a separate layer containing the host material, but lacking the fluorescent material, can be interposed between the luminescent zone and the cathode. Although the additional interposed organic electron injection layer can be of any conventional form, it is preferred that both the electron injection layer and the layer forming the luminescent zone be present in the form of a thin film (less than 1µm in thickness) and most preferred that these layers have a combined thickness no greater than those thicknesses indicated above for the luminescent zone.

The organic electroluminescent medium of the EL devices of this invention preferably contains at least two separate organic layers. At least one such layer forms a zone for transporting electrons injected from the cathode and at least one layer forms a zone for transporting holes injected from the anode. As is more specifically taught by Van Slyke et al U.S. Patent 4,720,432, cited above, the latter zone is in turn preferably formed of at least two layers. One layer is in contact with the anode, providing a hole injecting zone. The other is between the hole injecting zone and the electron transporting zone and provides a hole transporting zone. While the preferred embodiments of matrix addressed organic EL devices according to this invention employ at least three separate organic layers, as taught by Van Slyke et al, it is appreciated that either the layer forming the hole injecting zone or the layer forming the hole transporting zone can be omitted and the remaining layer will perform both functions. Higher initial and sustained performance levels of the organic EL devices of this invention are realized when the separate hole injecting and hole transporting layers described below are employed in combination.

A layer containing a porphyrinic compound preferably forms the hole injecting zone of the matrix addressed organic EL device of the invention. A porphyrinic compound is any compound, natural or

synthetic, which is derived from or includes a porphyrin structure, including porphine itself. Any of the porphyrinic compounds disclosed by Adler U.S. Patent 3,935,031 or Tang U.S. Patent 4,356,429 can be employed.

Preferred porphyrinic compounds are those of structural formula (XVIII):

(XVIII)

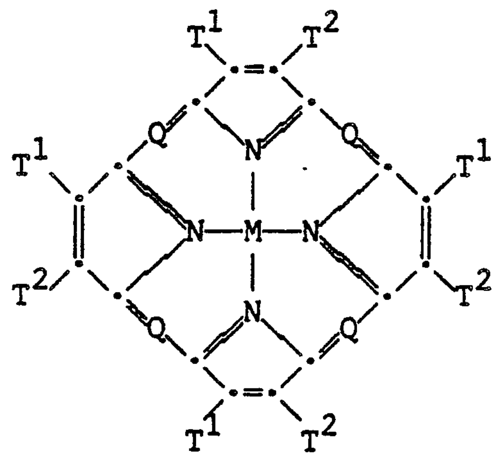

wherein
Q is -N= or -C(R)=;
M is a metal, metal oxide, or metal halide;
R is hydrogen, alkyl, aralkyl, aryl, or alkaryl, and
$T^1$ and $T^2$ represent hydrogen or together complete a unsaturated 6 membered ring, which can include substituents, such as alkyl or halogen. Preferred 6 membered rings are those formed of carbon, sulfur, and nitrogen ring atoms. Preferred alkyl moieties contain from about 1 to 6 carbon atoms while phenyl constitutes a preferred aryl moiety.

In an alternative preferred form the porphyrinic compounds differ from those of structural formula (XVIII) by substitution of two hydrogen for the metal atom, as indicated by formula (IXX):

(IXX)

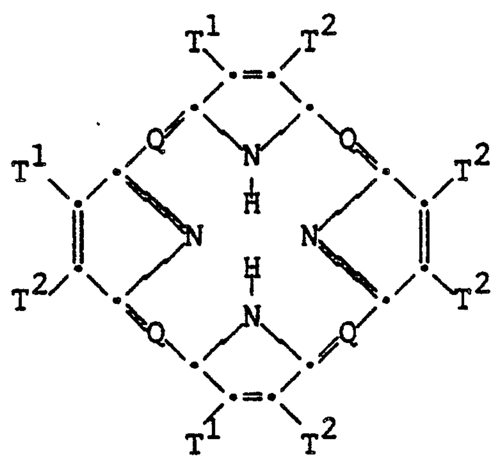

Highly preferred examples of useful porphyrinic compounds are metal free phthalocyanines and metal containing phthalocyanines. While the porphyrinic compounds in general and the phthalocyanines in particular can contain any metal, the metal preferably has a positive valence of two or higher. Exemplary preferred metals are cobalt, magnesium, zinc, palladium, nickel, and, particularly, copper, lead, and platinum.

Illustrative of useful porphyrinic compounds are the following:

| | |
|---|---|
| PC-1 | Porphine |
| PC-2 | 1,10,15,20-Tetraphenyl-21H,23H-porphine copper (II) |
| PC-3 | 1,10,15,20-Tetraphenyl-21H,23H-porphine zinc (II) |
| PC-4 | 5,10,15,20-Tetrakis(pentafluorophenyl)-21H,23H-porphine |
| PC-5 | Silicon phthalocyanine oxide |
| PC-6 | Aluminum phthalocyanine chloride |
| PC-7 | Phthalocyanine (metal free) |
| PC-8 | Dilithium phthalocyanine |
| PC-9 | Copper tetramethylphthalocyanine |
| PC-10 | Copper phthalocyanine |
| PC-11 | Chromium phthalocyanine fluoride |
| PC-12 | Zinc phthalocyanine |
| PC-13 | Lead phthalocyanine |
| PC-14 | Titanium phthalocyanine oxide |
| PC-15 | Magnesium phthalocyanine |
| PC-16 | Copper octamethylphthalocyanine |

The hole transporting layer of the organic EL device contains at least one hole transporting aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel et al U.S. Patent 3,180,730. Other suitable triarylamines substituted with vinyl or vinylene radicals and/or containing at least one active hydrogen containing group are disclosed by Brantley et al U.S. Patents 3,567,450 and 3,658,520.

A preferred class of aromatic tertiary amines are those which include at least two aromatic tertiary amine moieties. Such compounds include those represented by structural formula (XX):

(XX)

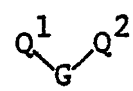

wherein

$Q^1$ and $Q^2$ are independently aromatic tertiary amine moieties and

G is a linking group such an arylene, cycloalkylene, or alkylene group or a carbon to carbon bond.

A particularly preferred class of class of triarylamines satisfying structural formula (XX) and containing two triarylamine moieties are those satisfying structural formula (XXI):

(XXI)

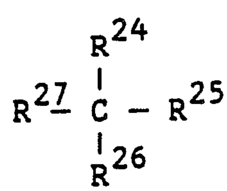

where

$R^{24}$ and $R^{25}$ each independently represents a hydrogen atom, an aryl group, or an alkyl group or $R^{24}$ and $R^{25}$ together represent the atoms completing a cycloalkyl group and

$R^{26}$ and $R^{27}$ each independently represents an aryl group which is in turn substituted with a diaryl substituted amino group, as indicated by structural formula (XXII):

(XXII)

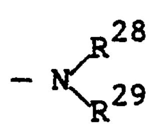

wherein $R^{28}$ and $R^{29}$ are independently selected aryl groups.

Another preferred class of aromatic tertiary amines are tetraaryldiamines. Preferred tetraaryldiamines include two diarylamino groups, such as indicated by formula (XXII), linked through an arylene group. Preferred tetraaryldiamines include those represented by formula (XXIII).

(XXIII)

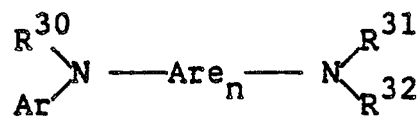

wherein
Are is an arylene group,
n is an integer of from 1 to 4, and
Ar, $R^{30}$, $R^{31}$, and $R^{32}$ are independently selected aryl groups.

The various alkyl, alkylene, aryl, and arylene moieties of the foregoing structural formulae (XX), (XXI), (XXII), and (XXIII) can each in turn be substituted. Typical substituents including alkyl groups, alkoxy groups, aryl groups, aryloxy groups, and halogen such as fluoride, chloride, and bromide. The various alkyl and alkylene moieties typically contain from about 1 to 6 carbon atoms. The cycloalkyl moieties can contain from 3 to about 10 carbon atoms, but typically contain five, six, or seven ring carbon atoms-e.g., cyclopentyl, cyclohexyl, and cycloheptyl ring structures. The aryl and arylene moieties are preferably phenyl and phenylene moieties.

While the entire hole transporting layer of the organic electroluminescent medium can be formed of a single aromatic tertiary amine, it is a further recognition of this invention that increased stability can be realized by employing a combination of aromatic tertiary amines. Specifically, it has been observed that employing a triarylamine, such as a triarylamine satisfying formula (XXI), in combination with a tetraaryldiamine, such as indicated by formula (XXIII), can be advantageous. When a triarylamine is employed in combination with a tetraaryldiamine, the latter is positioned as a layer interposed between the triarylamine and the electron injecting and transporting layer.

Representative useful aromatic tertiary amines are disclosed by Berwick et al U.S. Patent 4,175,960 and Van Slyke et al U.S. Patent 4,539,507. Berwick et al in addition discloses as useful hole transporting compounds N-substituted carbazoles, which can be viewed as ring bridged variants of the diaryl and triarylamines disclosed above.

Illustrative of useful aromatic tertiary amines are the following:

| | |
|---|---|
| ATA-1 | 1,1-Bis(4-di-p-tolylaminophenyl)cyclohexane |
| ATA-2 | 1,1-Bis(4-di-p-tolylaminophenyl)-4-phenylcyclohexane |
| ATA-3 | 4,4′-Bis(diphenylamino)quadriphenyl |
| ATA-4 | Bis(4-dimethylamino-2-methylphenyl)phenylmethane |
| ATA-5 | N,N,N,-Tri(p-tolyl)amine |
| ATA-6 | 4-(di-p-tolylamino)-4′-[4(di-p-tolylamino)styryl]stilbene |
| ATA-7 | N,N,N′,N′-Tetra-p-tolyl-4,4′-diaminobiphenyl |
| ATA-8 | N,N,N′,N′-Tetraphenyl-4,4′-diaminobiphenyl |
| ATA-9 | N-Phenylcarbazole |
| ATA-10 | Poly(N-vinylcarbazole) |

Any conventional electron injecting and transporting compound or compounds can be employed in forming the layer of the organic electroluminescent medium adjacent the cathode. This layer can be formed by historically taught electroluminescent materials, such as anthracene, naphthalene, phenanthrene, pyrene, chrysene, and perylene and other fused ring electroluminescent materials containing up to about 8 fused rings as illustrated by Gurnee et al U.S. Patent 3,172,862, Gurnee U.S. Patent 3,173,050, Dresner, "Double Injection Electroluminescence in Anthracene", RCA Review, Vol. 30, pp. 322-334, 1969; and Dresner U.S. Patent 3,710,167, cited above. Although such fused ring electroluminescent materials do not lend themselves to forming thin (less than 1µm) films and therefore do not lend themselves to achieving the highest attainable EL device performance levels, organic EL devices incorporating such electroluminescent materials when constructed according to the invention show improvements in performance and stability over prior art EL devices.

In the matrix addressed organic EL devices of the invention it is possible to maintain a current density compatible with efficient light emission while employing a relatively low voltage across the electrodes by

limiting the total thickness of the organic electroluminescent medium to less than 1µm (10,000 Angstroms). At a thickness of less than 1µm an applied voltage of 20 volts results in a field potential of greater than 2 X $10^5$ volts/cm, which is compatible with efficient light emission. An order of magnitude reduction (to 0.1µm or 1000 Angstroms) in thickness of the organic electroluminescent medium, allowing further reductions in applied voltage and/or increase in the field potential and hence current density, are well within device construction capabilities.

One function which the organic electroluminescent medium performs is to provide a dielectric barrier to prevent shorting of the electrodes on electrical biasing of the EL device. Even a single pin hole extending through the organic electroluminescent medium will allow shorting to occur. The presence of three superimposed organic layers greatly reduces the chance of pin holes in the layers being aligned to provide a continuous conduction path between the electrodes. This in itself permits one or even two of the layers of the organic electroluminescent medium to be formed of materials which are not ideally suited for film formation on coating while still achieving acceptable EL device performance and reliability.

The preferred materials for forming the organic electroluminescent medium are each capable of fabrication in the form of a thin film-that is, capable of being fabricated as a continuous layer having a thickness of less than 0.5µm or 5000 Angstroms.

When one or more of the layers of the organic electroluminescent medium are solvent coated, a film forming polymeric binder can be conveniently codeposited with the active material to assure a continuous layer free of structural defects, such as pin holes. If employed, a binder must, of course, itself exhibit a high dielectric strength, preferably at least about 2 X $10^6$ volt/cm. Suitable polymers can be chosen from a wide variety of known solvent cast addition and condensation polymers. Illustrative of suitable addition polymers are polymers and copolymers (including terpolymers) of styrene, t-butylstyrene, N-vinyl carbazole, vinyltoluene, methyl methacrylate, methyl acrylate, acrylonitrile, and vinyl acetate. Illustrative of suitable condensation polymers are polyesters, polycarbonates, polyimides, and polysulfones. To avoid unnecessary dilution of the active material, binders are preferably limited to less than 50 percent by weight, based on the total weight of the material forming the layer.

The preferred active materials forming the organic electroluminescent medium are each film forming materials and capable of vacuum vapor deposition. Extremely thin defect free continuous layers can be formed by vacuum vapor deposition. Specifically, individual layer thicknesses as low as about 50 Angstroms can be present while still realizing satisfactory EL device performance. Employing a vacuum vapor deposited porphorinic compound as a hole injecting layer, a film forming aromatic tertiary amine as a hole transporting layer (which can in turn be comprised of a triarylamine layer and a tetraaryldiamine layer), and a chelated oxinoid compound as an electron injecting and transporting layer, individual layer thicknesses in the range of from about 50 to 5000 Angstroms are contemplated, with layer thicknesses in the range of from 100 to 2000 Angstroms being preferred. It is generally preferred that the overall thickness of the organic electroluminescent medium be at least about 1000 Angstroms.

Where it is intended to transmit light from the organic EL device through the anode strips, this can be conveniently achieved by forming thin conductive strips on a light transmissive substrate-e.g., a transparent or translucent glass plate or plastic film. In one form the organic EL devices of this invention can follow the historical practice of including a light transmissive anode formed of tin oxide or indium tin oxide coated on a glass plate, as disclosed by Gurnee et al U.S. Patent 3,172,862, Gurnee U.S. Patent 3,173,050, Dresner, "Double Injection Electroluminescence in Anthracene", RCA Review, Vol. 30, pp. 322-334, 1969; and Dresner U.S. Patent 3,710,167, cited above. While any light transmissive polymeric film can be employed as a substrate, Gillson U.S. Patent 2,733,367 and Swindells U.S. Patent 2,941,104 disclose polymeric films specifically selected for this purpose.

As employed herein the term "light transmissive" means simply that the layer or element transmits greater than 50 percent of the light of at least one wavelength and preferably over at least a 100 nm interval. Since both specular (unscattered) and diffused (scattered) emitted light are desirable device outputs, both translucent and transparent or substantially transparent materials are useful. In most instances the light transmissive layers or elements of the organic EL device are also colorless or of neutral optical density-that is, exhibiting no markedly higher absorption of light in one wavelength range as compared to another. However, it is, of course, recognized that the light transmissive electrode supports or separate superimposed films or elements can be tailored in their light absorption properties to act as emission trimming filters, if desired. Such an electrode construction is disclosed, for example, by Fleming U.S. Patent 4,035,686. The light transmissive conductive strips of the electrodes, where fabricated of thicknesses approximating the wavelengths or multiples of the light wavelengths received can act as interference filters.

Contrary to historical practice, in one preferred form the organic EL devices of this invention emit light through the cathode rather than the anode. This relieves the anode of any requirement that it be light

transmissive, and it is, in fact, preferably opaque to light in this form of the invention. Opaque anodes can be formed of any metal or combination of metals having a suitably high work function for anode construction. Preferred anode metals have a work function of greater than 4 electron volts (eV). Suitable anode metals can be chosen from among the high (> 4 eV) work function metals listed below. An opaque anode can be formed of an opaque metal layer on a support or as a separate metal foil or sheet. Opaque anodes having thicknesses up to 5 μm or more contemplated, although thicknesses of less than 1 μm have adequate electrical conductivity and are generally preferred.

The organic EL devices of this invention can employ a cathode constructed of any metal, including any high or low work function metal, heretofore taught to be useful for this purpose. Unexpected fabrication, performance, and stability advantages have been realized by forming the cathode of a combination of a low work function metal and at least one other metal. A low work function metal is herein defined as a metal having a work function of less than 4 eV. Generally the lower the work function of the metal, the lower the voltage required for electron injection into the organic electroluminescent medium. However, alkali metals, the lowest work function metals, are too reactive to achieve stable EL device performance with simple device constructions and construction procedures and are excluded (apart from impurity concentrations) from the preferred cathodes of this invention.

Available low work function metal choices for the cathode (other alkali metals) are listed below by periods of the Periodic Table of Elements and categorized into 0.5 eV work function groups. All work functions provided are taken Sze, Physics of Semiconductor Devices, Wiley, N.Y., 1969, p. 366.

| Period | Element | Work Function By eV Group |
|---|---|---|
| 2 | Beryllium | 3.5 – 4.0 |
| 3 | Magnesium | 3.5 – 4.0 |
| 4 | Calcium | 2.5 – 3.0 |
| | Scandium | 3.0 – 3.5 |
| | Titanium | 3.5 – 4.0 |
| | Manganese | 3.5 – 4.0 |
| | Gallium | 3.5 – 4.0 |
| 5 | Strontium | 2.0 – 2.5 |
| | Yttrium | 3.0 – 3.5 |
| | Indium | 3.5 – 4.0 |
| 6 | Barium | ~2.5 |
| | Lanthanum | 3.0 – 3.5 |
| | Cerium | 2.5 – 3.0 |
| | Praseodymium | 2.5 – 3.0 |
| | Neodymium | 3.0 – 3.5 |
| | Promethium | 3.0 – 3.5 |
| | Samarium | 3.0 – 3.5 |
| | Europium | 2.5 – 3.0 |
| | Gadolinium | 3.0 – 3.5 |
| | Terbium | 3.0 – 3.5 |
| | Dysprosium | 3.0 – 3.5 |
| | Holmium | 3.0 – 3.5 |
| | Erbium | 3.0 – 3.5 |
| | Thulium | 3.0 – 3.5 |
| | Ytterbium | 2.5 – 3.0 |
| | Lutetium | 3.0 – 3.5 |
| | Hafnium | ~3.5 |
| 7 | Radium | 3.0 – 3.5 |
| | Actinium | 2.5 – 3.0 |

| | |
|---|---|
| Thorium | 3.0 – 3.5 |
| Uranium | 3.0 – 3.5 |

From the foregoing listing it is apparent that the available low work function metals for the most part belong to the Group IIa or alkaline earth group of metals, the Group III group of metals (including the rare earth metals-i.e. yttrium and the lanthanides, but excluding boron and aluminum), and the actinide groups of metals. The alkaline earth metals, owing to their ready availability, low cost, ease of handling, and minimal

adverse environmental impact potential, constitute a preferred class of low work function metals for use in the cathodes of EL devices of this invention. Magnesium and calcium are particularly preferred. Though significantly more expensive, the included Group III metals, particularly the rare earth metals, possess similar advantages and are specifically contemplated as preferred low work function metals. The low work function metals exhibiting work functions in the range of from 3.0 to 4.0 eV are generally more stable than metals exhibiting lower work functions and are therefore generally preferred.

A second metal included in the construction of the cathode has as one primary purpose to increase the stability (both storage and operational) of the cathode. It can be chosen from among any metal other than an alkali metal. The second metal can itself be a low work function metal and thus be chosen from the metals listed above having a work function of less than 4 eV, with the same preferences above discussed being fully applicable. To the extent that the second metal exhibits a low work function it can, of course, supplement the first metal in facilitating electron injection.

Alternatively, the second metal can be chosen from any of the various metals having a work function greater than 4 eV, which includes the elements more resistant to oxidation and therefore more commonly fabricated as metallic elements. To the extent the second metal remains invariant in the organic EL device as fabricated, it contributes to the stability of the device.

Available higher work function (4 eV or greater) metal choices for the cathode are listed below by periods of the Periodic Table of Elements and categorized into 0.5 eV work function groups.

| Period | Element | Work Function By eV Group |
|---|---|---|
| 2 | Boron | ~4.5 |
| | Carbon | 4.5 – 5.0 |
| 3 | Aluminum | 4.0 – 4.5 |
| 4 | Vanadium | 4.0 – 4.5 |
| | Chromium | 4.5 – 5.0 |
| | Iron | 4.0 – 4.5 |
| | Cobalt | 4.0 – 4.5 |
| | Nickel | ~4.5 |
| | Copper | 4.0 – 4.5 |
| | Zinc | 4.0 – 4.5 |
| | Germanium | 4.5 – 5.0 |
| | Arsenic | 5.0 – 5.5 |
| | Selenium | 4.5 – 5.0 |
| 5 | Molybdenum | 4.0 – 4.5 |
| | Technetium | 4.0 – 4.5 |
| | Ruthenium | 4.5 – 5.0 |
| | Rhodium | 4.5 – 5.0 |
| | Palladium | 4.5 – 5.0 |
| | Silver | 4.0 – 4.5 |
| | Cadmium | 4.0 – 4.5 |
| | Tin | 4.0 – 4.5 |
| | Antimony | 4.0 – 4.5 |
| | Tellurium | 4.5 – 5.0 |
| 6 | Tantalum | 4.0 – 4.5 |
| | Tungsten | ~4.5 |

| | |
|---|---|
| Rhenium | ~5.0 |
| Osmium | 4.5 – 5.0 |
| Iridium | 5.5 – 6.0 |
| Platinum | 5.5 – 6.0 |
| Gold | 4.5 – 5.0 |
| Mercury | ~4.5 |
| Lead | ~4.0 |
| Bismuth | 4.0 – 4.5 |
| Polonium | 4.5 – 5.0 |

From the foregoing listing of available metals having a work function of 4 eV or greater attractive higher work function metals for the most part are accounted for aluminum, the Group Ib metals (copper, silver, and gold), the metals in Groups IV, V, and VI, and the Group VIII transition metals, particularly the noble metals from this group. Aluminum, copper, silver, gold, tin, lead, bismuth, tellurium, and antimony are particularly preferred higher work function second metals for incorporation in the cathode.

There are several reasons for not restricting the choice of the second metal based on either its work function or oxidative stability. The second metal is only a minor component of the cathode. One of its primary functions is to stabilize the first, low work function metal, and, surprisingly, it accomplishes this objective independent of its own work function and susceptibility to oxidation.

A second valuable function which the second metal performs is to reduce the sheet resistance of the cathode as a function of the thickness of the cathode. Since acceptably low sheet resistance levels (less than 100 ohms per square) can be realized at low cathode thicknesses (as low as 100 Angstroms), cathodes can be formed which exhibit high levels of light transmission. Light transmissive cathode strips are contemplated having thicknesses in the range of from 100 to 400 µm (preferably 150 to 250 µm). The second metal permits thin, transparent cathodes of acceptably low resistance levels and high electron injecting efficiencies to be achieved of enhanced stability. This in turn permits (but does not require) the organic EL devices of this invention to be constructed with light transmissive cathodes and frees the organic EL devices of any necessity of having a light transmissive anode to achieve light emission through an electrode area. When the cathode strips are not intended to be light transmissive, their thicknesses can range up to 1 µm or more.

A third valuable function which the second metal has been observed to perform is to facilitate vacuum vapor deposition of a first metal onto the organic electroluminescent medium of the EL device. In vapor deposition less metal is deposited on the walls of the vacuum chamber and more metal is deposited on the organic electroluminescent medium when a second metal is also deposited. The efficacy of the second metal in stabilizing organic EL device, reducing the sheet resistance of thin cathodes, and in improving acceptance of the first metal by the organic electroluminescence medium is demonstrated by the examples below.

Only a very small proportion of a second metal need be present to achieve these advantages. Only about 0.1 percent of the total metal atoms of the cathode need be accounted for by the second metal to achieve a substantial improvement. Where the second metal is itself a low work function metal, both the first and second metals are low work function metals, and it is immaterial which is regarded as the first metal and which is regarded as the second metal. For example, the cathode composition can range from about 0.1 percent of the metal atoms of the cathode being accounted for by one low work function metal to about 0.1 percent of the total metal atoms being accounted for by a second low work function metal. Preferably one of the two metals account for at least 1 percent and optimally at least 2 percent of the total metal present.

When the second metal is a relatively higher (at least 4.0 eV) work function metal, the low work function metal preferably accounts for greater than 50 percent of the total metal atoms of the cathode. This is to avoid reduction in electron injection efficiency by the cathode, but it is also predicated on the observation that the benefits of adding a second metal are essentially realized when the second metal accounts for less than 20 percent of the total metal atoms of the cathode.

Although the foregoing discussion has been in terms of a binary combination of metals forming the cathode, it is, of course, appreciated that combinations of three, four, or even higher numbers of metals are possible and can be employed, if desired. The proportions of the first metal noted above can be accounted for by any convenient combination of low work function metals and the proportions of the second metal can be accounted for any combination of high and/or low work function metals.

While the second metal or metals can be relied upon to enhance electrical conductivity, their minor proportion of the total cathode metal renders it unnecessary that these metals be present in an electrically conducting form. The second metal or metals can be present as compounds (e.g., lead, tin, or antimony telluride) or in an oxidized form, such as in the form of one or more metal oxides or salts. Since the first, low work function metal or metals account for the major proportion of the cathode metal content and are relied upon for electron conduction, they are preferably employed in their elemental form, although some oxidation may occur on aging.

In depositing the first metal alone onto a substrate or onto the organic electroluminescent medium, whether from solution or, preferably, from the vapor phase, initial, spatially separated deposits of the first metal form nuclei for subsequent deposition. Subsequent deposition leads to the growth of these nuclei into microcrystals. The result is an uneven and random distribution of microcrystals, leading to a non-uniform cathode. By presenting a second metal during at least one of the nucleation and growth stages and,

preferably, both, the high degree of symmetry which a single element affords is reduced. Since no two substances form crystal cells of exactly the same habit and size, any second metal reduces the degree of symmetry and at least to some extent acts to retard microcrystal growth. Where the first and second metals have distinctive crystal habits, spatial symmetry is further reduced and microcrystal growth is further retarded. Retarding microcrystal growth favors the formation of additional nucleation sites. In this way the number of deposition sites is increased and a more uniform coating is achieved.

Depending upon the specific choice of metals, the second metal, where more compatible with the substrate, can produce a disproportionate number of the nucleation sites, with the first metal then depositing at these nucleation sites. Such a mechanism may, if fact, account for the observation that, with a second metal present, the efficiency with which the first metal is accepted by a substrate is significantly enhanced. It has been observed, for example, that less deposition of the first metal occurs on vacuum chamber walls when a second metal is being codeposited.

The first and second metals of the cathode are intimately intermingled, being codeposited. That is, the deposition of neither the first nor second metals is completed before at least a portion of the remaining metal is deposited. Simultaneous deposition of the first and second metals is generally preferred. Alternatively, successive incremental depositions of the first and second metals can be undertaken, which at their limit may approximate concurrent deposition.

While not required, the cathode, once formed can be given post treatments. For example, the cathode may be heated within the stability limits of the substrate in a reducing atmosphere. Other action on the cathode can be undertaken as a conventionally attendant feature of lead bonding or device encapsulation.

## Claims

1. An electroluminescent device comprised of an anode, a planar electroluminescent medium coated on the anode, and a cathode coated on the planar electroluminescent medium,
characterized in that
said planar electroluminescent medium is comprised of an organic hole injecting zone adjacent said anode and an organic electron injecting luminescent zone adjacent said cathode,
said anode is comprised of a plurality of laterally spaced strips contacting said organic hole injecting zone, said strips having a center-to-center spacing of less than 400µm,
said cathode is comprised of a plurality of laterally spaced strips contacting said organic electron injecting luminescent zone, said strips having a center-to-center spacing of less than 400µm, and
said cathode and anode strips are relatively oriented to be in part superimposed over and in part laterally offset from each other.

2. An electroluminescent device according to claim 1 further characterized in that said cathode strips are oriented with their major axes substantially parallel, said anode strips are oriented with their major axes parallel, and, when viewed in a direction normal to said planar electroluminescent medium, said major axes of said cathode strips are angularly oriented relative to said major axes of said anode strips at an angle ranging from 30 to 150 degrees.

3. An electroluminescent device according to claim 2 further characterized in that, when viewed in a directed normal to said planar electroluminescent medium, said major axes of said cathode and anode strips are essentially perpendicular to each other.

4. A device according to any one of claims 1 to 3 inclusive further characterized in that said cathode strips exhibit a thickness in the range of from 100 Angstroms to 1 µm.

5. A device according to any one of claims 1 to 4 inclusive further characterized in that the total thickness of the electroluminescent medium is less than 1µm.

6. A device according to claim 5 further characterized in that the total thickness of the electroluminescent medium is in the range from 0.1 to 0.5µm.

7. A device according to any one of claims 1 to 6 inclusive further characterized in that the center-to-center spacing of said strips is less than 300µm.

8. A device according to claim 7 further characterized in that the center-to-center spacing of said strips is less than 100µm.

9. A device according to any one of claims 1 to 8 inclusive further characterized in that said cathode is comprised of a plurality of metals other than an alkali metal, at least one of said metals having a work function of less than 4 eV.

10. An electroluminescent device according to any one of claims 1 to 9 inclusive further characterized in that said organic hole injecting zone is comprised of

a layer in contact with said anode containing a hole injecting porphyrinic compound and
a layer containing a hole transporting aromatic tertiary amine interposed between said hole injection layer and said electron injecting luminescent zone.

11. An electroluminescent device according to any one of claims 1 to 10 inclusive further characterized in that said electron injecting luminescent zone exhibits a thickness of less than 1 μm and is comprised of an organic host material capable of sustaining both hole and electron injection and
a fluorescent material capable of emitting light in response to hole-electron recombination.

12. An electroluminescent device according to claim 11 in which said fluorescent material is chosen to provide favored sites for light emission.

13. An electroluminescent device according to claim 11 or 12 in which said fluorescent material is located in a layer containing said organic host material and in contact with said organic hole injecting zone.

14. An electroluminescent device according to any one of claims 11 to 13 inclusive in which said fluorescent material has a bandgap no greater than that of said host material and a reduction potential less negative than that of said host material.

15. An electroluminescent device according to any one of claims 11 to 14 inclusive in which said fluorescent material is a dye.

16. An electroluminescent device according to claim 15 in which said dye is chosen from the class consisting of coumarin, dicyanomethylenepyrans and thiopyrans, polymethine, oxabenzanthracene, xanthene, pyrylium and thiapyrylium, carbostyril, and perylene fluorescent dyes.

17. An electroluminescent device according to claim 16 in which said fluorescent dye is a coumarin dye of the formula:

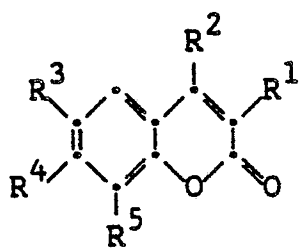

where
$R^1$ is chosen from the group consisting of hydrogen, carboxy, alkanoyl, alkoxycarbonyl, cyano, aryl, and a heterocylic aromatic group,
$R^2$ is chosen from the group consisting of hydrogen, alkyl, haloalkyl, carboxy, alkanoyl, and alkoxycarbonyl,
$R^3$ is chosen from the group consisting of hydrogen and alkyl,
$R^4$ is an amino group, and
$R^5$ is hydrogen, or
$R^1$ and $R^2$ together form a fused carbocyclic ring, and/or
the amino group forming $R^4$ independently completes with at least one of $R^3$ and $R^5$ a fused ring.

18. An electroluminescent device according to claim 16 in which said fluorescent dye is a dye of the formula:

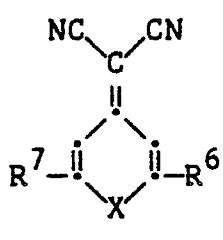

where
X represents oxygen or sulfur;
$R^6$ represents a 2-(4-aminostyryl) group; and
$R^7$ represents a second $R^6$ group, an alkyl group, or an aryl group.

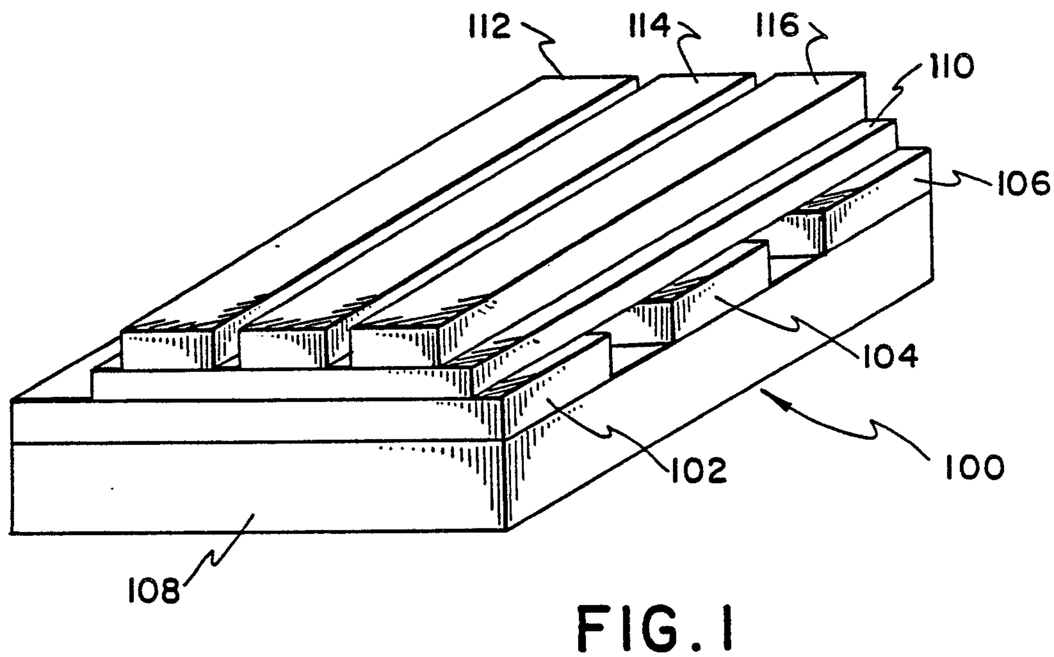


FIG. 1

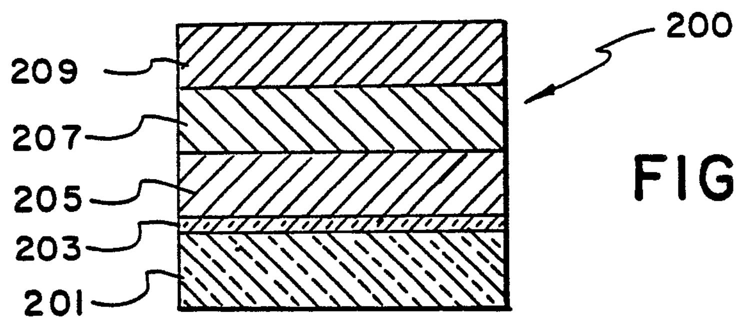


FIG. 2

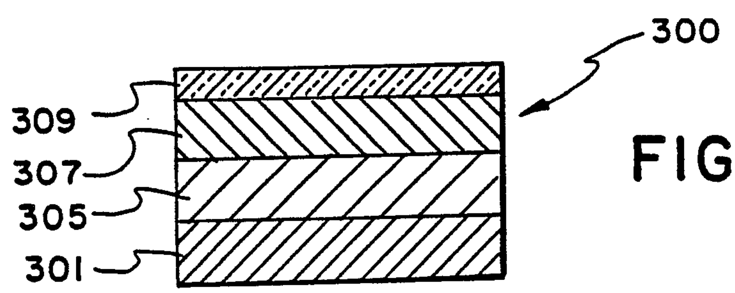


FIG. 3